(19) Europäisches Patentamt
European Patent Office
Office européen des brevets

(11) EP 4 397 504 A1

(12) EUROPEAN PATENT APPLICATION
published in accordance with Art. 153(4) EPC

(43) Date of publication:
**10.07.2024 Bulletin 2024/28**

(21) Application number: **22864574.3**

(22) Date of filing: **30.08.2022**

(51) International Patent Classification (IPC):
***B41N 3/03*** *(2006.01)* ***B41C 1/10*** *(2006.01)*
***B41N 1/08*** *(2006.01)*

(52) Cooperative Patent Classification (CPC):
**B41C 1/10; B41N 1/08; B41N 3/03**

(86) International application number:
**PCT/JP2022/032630**

(87) International publication number:
**WO 2023/032992 (09.03.2023 Gazette 2023/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.08.2021 JP 2021141582**

(71) Applicant: **FUJIFILM Corporation**
**Tokyo 106-8620 (JP)**

(72) Inventors:
- **MATSUURA, Atsushi**
  **Haibara-gun, Shizuoka 421-0396 (JP)**
- **ARIMURA, Keisuke**
  **Haibara-gun, Shizuoka 421-0396 (JP)**

(74) Representative: **HGF**
**HGF Limited**
**1 City Walk**
**Leeds LS11 9DX (GB)**

# (54) LITHOGRAPHIC PRINTING PLATE SUPPORT, LITHOGRAPHIC PRINTING PLATE PRECURSOR, AND METHOD FOR PRODUCING LITHOGRAPHIC PRINTING PLATE

(57) The present invention provides a support for a lithographic printing plate, from which a lithographic printing plate precursor having excellent scratch resistance can be obtained by combining the support with an image recording layer, a lithographic printing plate precursor, and a method of producing a lithographic printing plate. The support for a lithographic printing plate according to the present invention, including an aluminum plate, and an anodized aluminum film disposed on the aluminum plate, in which a plurality of projections are present on a surface of the support for a lithographic printing plate on a side of the anodized film, an average value of equivalent circular diameters of the projections in a cut surface at a position that is 0.5 μm greater than a position of the projections with an average height is in a range of 3.0 to 10.0 μm, and a density of the projections with a height of 0.5 μm or greater from the position of the projections with the average height is in a range of 3,000 to 9,000 pc/mm$^2$.

FIG. 2

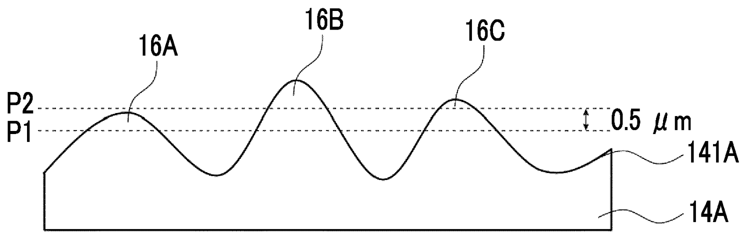


EP 4 397 504 A1

## Description

## BACKGROUND OF THE INVENTION

1. Field of the Invention

The present invention relates to a support for a lithographic printing plate, a lithographic printing plate precursor, and a method of producing a lithographic printing plate.

2. Description of the Related Art

From the viewpoint that an aluminum support used in a lithographic printing plate improves stain resistance and printing durability in a case where a lithographic printing plate is obtained from the aluminum support, it is known that unevenness is imparted by graining (roughening treatment) a surface of an aluminum plate.

For example, WO2019/087516A discloses "lithographic printing plate precursor including an aluminum support and an image recording layer disposed on the aluminum support, in which the aluminum support includes an aluminum plate and an anodized aluminum film disposed on the aluminum plate, the image recording layer is disposed on the aluminum support on a side of the anodized film, and a density of recesses with a depth of 0.70 μm or greater from a center line, which is obtained by measuring a surface of the aluminum support on a side of the image recording layer in an area of 400 μm × 400 μm using a non-contact three-dimensional roughness meter, is 3,000 pc/mm$^2$ or greater.

## SUMMARY OF THE INVENTION

In recent years, lithographic printing plate precursors including a support for a lithographic printing plate have been required to have further improved scratch resistance.

As a result of examination on the lithographic printing plate precursor including the support for a lithographic printing plate described in WO2019/087516A, the present inventors found that the scratch resistance does not satisfy the characteristics that have been currently required even through the scratch resistance satisfies the mild required characteristics of the related art, and thus the lithographic printing plate precursor is required to be further improved.

An object of the present invention is to provide a support for a lithographic printing plate, from which a lithographic printing plate precursor having excellent scratch resistance can be obtained by combining the support with an image recording layer.

Further, an object of the present invention is to provide a lithographic printing plate precursor and a method of producing a lithographic printing plate.

The present inventors found that the above-described problems can be solved by employing the following configurations.

(1) A support for a lithographic printing plate, comprising: an aluminum plate; and an anodized aluminum film disposed on the aluminum plate, in which a plurality of projections are present on a surface of the support for a lithographic printing plate on a side of the anodized film, an average value of equivalent circular diameters of the projections in a cut surface at a position that is 0.5 μm greater than a position of the projections with an average height is in a range of 3.0 to 10.0 μm, and a density of the projections with a height of 0.5 μm or greater from the position of the projections with the average height is in a range of 3,000 to 9,000 pc/mm$^2$.

(2) The support for a lithographic printing plate according to (1), in which the average value of the equivalent circular diameters is in a range of 3.0 to 6.5 μm.

(3) The support for a lithographic printing plate according to (1) or (2), in which the density of the projections is in a range of 4,000 to 9,000 pc/mm$^2$.

(4) The support for a lithographic printing plate according to any one of (1) to (3), in which a ratio of the density to the average value of the equivalent circular diameters is 500 (pc/mm$^2$)/μm or greater.

(5) The support for a lithographic printing plate according to any one of (1) to (4), in which an amount of the anodized film is 2.0 g/m$^2$ or greater.

(6) The support for a lithographic printing plate according to any one of (1) to (5), in which an amount of the anodized film is 3.2 g/m$^2$ or greater.

(7) The support for a lithographic printing plate according to any one of (1) to (6), in which a surface area ratio ΔS calculated according to Equation (1), from a geometrically measured area S0 and an actual area Sx determined by an approximate three-point method from three-dimensional data obtained by measuring 512 × 512 points with an area of 25 μm × 25 μm on the surface on the side of the anodized film using an atomic force microscope, is 20% or greater.

$$\Delta S = (Sx - S0)/S0 \times 100\ (\%) \cdots (1)$$

(8) The support for a lithographic printing plate according to any one of (1) to (7), in which the anodized film has micropores, the micropores are formed of large-diameter pore portions extending to a position at a depth of 10 to 1,000 nm from the surface of the anodized film and small-diameter pore portions communicating with bottom portions of the large-diameter pore portions and extending to a position at a depth of 20 to 2,000 nm from communication positions, an average diameter of the large-diameter pore portions in the surface of the anodized film is in a range of 18 to 60 nm, and an average diameter of the small-diameter pore portions at the communication positions is 15 nm or less.

(9) The support for a lithographic printing plate according to any one of (1) to (7), in which the anodized film has micropores, the micropores are formed of upper pore portions extending in a depth direction from the surface of the anodized film and lower pore portions communicating with bottom portions of the upper pore portions and extending to a position at a depth of 20 to 2,000 nm from communication positions, an average diameter of the upper pore portions in the surface of the anodized film is in a range of 18 to 60 nm, a maximum diameter of the upper pore portions is 200 nm or less, an average diameter of the lower pore portions at the communication positions is 15 nm or less, and a ratio of the maximum diameter of the upper pore portions to the average diameter of the upper pore portions in the surface of the anodized film is 1.2 or greater.

(10) The support for a lithographic printing plate according to (8) or (9), in which a density of the micropores is in a range of 300 to 2,000 pc/$\mu m^2$.

(11) A lithographic printing plate precursor comprising: the support for a lithographic printing plate according to any one of (1) to (10); and an image recording layer.

(12) The lithographic printing plate precursor according to (11), in which the lithographic printing plate precursor is of an on-press development type.

(13) A method of producing a lithographic printing plate, comprising: a step of image-exposing the lithographic printing plate precursor according to (11) to an infrared laser; and a step of removing an unexposed portion of the image recording layer on a printing press by at least one selected from a printing ink or dampening water.

According to the present invention, it is possible to provide a support for a lithographic printing plate, from which a lithographic printing plate precursor having excellent scratch resistance can be obtained by combining the support with an image recording layer.

Further, according to the present invention, it is possible to provide a lithographic printing plate precursor and a method of producing a lithographic printing plate.

## BRIEF DESCRIPTION OF THE DRAWINGS

Fig. 1 is a schematic cross-sectional view illustrating an embodiment of a support for a lithographic printing plate of the present invention.

Fig. 2 is a view for describing a form of an anodized film of the support for a lithographic printing plate of the present invention.

Fig. 3 is a view for describing an equivalent circular diameter of a cross section of a projection.

Fig. 4 is a schematic cross-sectional view illustrating an embodiment of an anodized film.

Fig. 5 is a schematic cross-sectional view illustrating an embodiment of an anodized film.

Fig. 6 is a graph showing an example of an alternating waveform current waveform diagram used for an electrochemical roughening treatment according to a method of producing a support for a lithographic printing plate.

Fig. 7 is a side view illustrating an example of a radial type cell in the electrochemical roughening treatment carried out using an alternating current according to the method of producing a support for a lithographic printing plate.

Fig. 8 is a schematic cross-sectional view illustrating an embodiment of a lithographic printing plate precursor.

Fig. 9 is a schematic view illustrating an anodization treatment device used for an anodization treatment in preparation of a support for a lithographic printing plate.

## DESCRIPTION OF THE PREFERRED EMBODIMENTS

Hereinafter, the present invention will be described in detail.

The description of constituent elements below is made based on representative embodiments of the present invention in some cases, but the present invention is not limited to such embodiments.

In addition, in the present specification, a numerical range shown using "to" indicates a range including numerical values described before and after "to" as a lower limit and an upper limit.

Further, in the present specification, in a case where substitution or unsubstitution is not noted in regard to the notation of a group in a compound represented by a formula and the group may further have a substituent, the group includes not only an unsubstituted group but also a group having a substituent unless otherwise specified. For example, in a formula, the description of "R represents an alkyl group, an aryl group, or a heterocyclic group" means that "R represents an unsubstituted alkyl group, a substituted alkyl group, an unsubstituted aryl group, a substituted aryl group, an unsubstituted heterocyclic group, or a substituted heterocyclic group".

A support for a lithographic printing plate according to the embodiment of the present invention includes an aluminum plate, and an anodized aluminum film disposed on the aluminum plate, in which a plurality of projections are present on a surface of the support for a lithographic printing plate on a side of the anodized film, the average value of equivalent circular diameters of projections in a cut surface at a position that is 0.5 μm greater than a position of projections with an average height is in a range of 3.0 to 10.0 μm, and a density of projections with a height of 0.5 μm or greater from the position of the projections with the average height is in a range of 3,000 to 9,000 pc/$mm^2$.

Hereinafter, the support for a lithographic printing plate according to the embodiment of the present invention will be described in detail with reference to the accompanying drawings.

Fig. 1 is a schematic cross-sectional view illustrating an embodiment of a support for a lithographic printing plate of the present invention.

A support 10 for a lithographic printing plate illustrated in Fig. 1 has a laminated structure in which an aluminum plate 12 and an anodized aluminum film 14A (hereinafter, also simply referred to as "anodized film") are laminated in this order. Fig. 2 is an enlarged view illustrating a surface 141A of the anodized film 14A in Fig. 1 on a side opposite to the aluminum plate 12 side (that is, a surface of the support for a lithographic printing plate on the anodized film side), in which a plurality of projections (in Fig. 2, a first projection 16A, a second projection 16B, and a third projection 16C) are present on the surface 141A of the anodized film 14A. Further, in Fig. 2, only the three projections are described, but the aspect of the present invention is not limited to this figure.

Hereinafter, first, the average value of the equivalent circular diameters and the density, which are the feature points of the present invention, will be described.

In the support for a lithographic printing plate according to the embodiment of the present invention, a plurality of projections are present on the surface of the support for a lithographic printing plate on the side of the anodized film, and the average value of the equivalent circular diameters of projections in a cut surface at a position that is 0.5 μm greater than a position of projections with an average height is in a range of 3.0 to 10.0 μm.

The average value of the equivalent circular diameters will be described in more detail with reference to Figs. 2 and 3.

As described above, as illustrated in Fig. 2, a plurality of projections (the first projection 16A, the second projection 16B, and the third projection 16C) are present on the surface 141A of the anodized film 14A. First, the average height of the projections is calculated, and a position P1 with the average height is specified.

A method of calculating the above-described average height is as follows.

First, three-dimensional data of the surface of the anodized film with an area of 400 μm × 400 μm is determined in a non-contact manner using a non-contact three-dimensional roughness meter (VertScan, manufactured by Ryoka Systems Inc.). Further, the device contents and measurement conditions of the VertScan are as follows.

(1) Device contents

CCD camera: Sony HR-57
Objective lens: ×10
Lens barrel: ×1
Wavelength filter: 530 white

(2) Conditions for measurement

Measurement mode: wave
Visual field range: 400 μm × 400 μm
Scan range: start + 6 μm, stop -10 μm

Next, the obtained three-dimensional data is image-analyzed by selecting "complete interpolation", "surface correction polynomial", "secondary", and "particle analysis" in this order using software (VS-Viewer, manufactured by Ryoka System Inc.), and the position P1 of the average height of the projections is specified. Further, the average height P1 of the projections denotes the height obtained by averaging the height values of the entire measurement data related

to the surface of the anodized film in a measurement region.

Next, as illustrated in Fig. 2, a position P2 that is 0.5 μm greater than the position P1 of the calculated average height is specified.

Next, the equivalent circular diameters of the cut surface of the projections at the position P2 are calculated. In the aspect of Fig. 2, since the second projection 16B and the third projection 16C are present at positions greater than the position P2, cross sections derived from the second projection 16B and the third projection 16C are observed in the cut surface at the position P2 as illustrated in Fig. 3. Each of the equivalent circular diameters of each projection is calculated from the area of the projections in the cut surface, and the calculated values are arithmetically averaged to determine the average value of the equivalent circular diameters. In the aspect of Fig. 2, the equivalent circular diameter of the cross-sectional area of the second projection 16B at the position P2 and the equivalent circular diameter of the cross-sectional area of the third projection 16C at the position P2 are calculated and arithmetically averaged.

The equivalent circular diameter is the diameter of a circle having the same area as the cross-sectional area of each projection in the cut surface.

The above-described measurement is performed by measuring five sites per sample, calculating the average value of the equivalent circular diameters of projections at each site, determining the average value of the obtained five numerical values, and defining this value as the average value of the equivalent circular diameters of the projections defined in the support for a lithographic printing plate according to the embodiment of the present invention. In the present invention, this numerical value may be in the above-described range (3.0 to 10.0 μm).

In the support for a lithographic printing plate according to the embodiment of the present invention, the average value of the equivalent circular diameters is in a range of 3.0 to 10.0 μm, preferably in a range of 3.0 to 6.5 μm, and more preferably in a range of 3.0 to 5.0 μm from the viewpoint that the scratch resistance of a lithographic printing plate precursor including the support for a lithographic printing plate is more excellent (hereinafter, also simply referred to as "from the viewpoint that the effects of the present invention are more excellent").

Further, in the support for a lithographic printing plate according to the embodiment of the present invention, the density of projections with a height of 0.5 μm or greater from the position of the projections with the average height is in a range of 3,000 to 9,000 pc/mm$^2$.

For example, in Fig. 2, the second projection 16B and the third projection 16C correspond to the projections having a height of 0.5 μm or greater from the position P1 of the projections with the average height.

In the above-described range, the density thereof is preferably in a range of 4,000 to 9,000 pc/mm$^2$ and more preferably in a range of 6,000 to 9,000 pc/mm$^2$ from the viewpoint that the effects of the present invention are more excellent.

A method of calculating the density is as follows.

First, three-dimensional data of the surface of the anodized film is acquired according to the same procedure as in the method of calculating the average height described above, the obtained three-dimensional data is image-analyzed using software (SX-Viewer, manufactured by Ryoka Systems Inc.) to specify the position of the projections with the average height, and the number of projections with a height that is 0.5 μm or greater than the position of the projections with the average height is determined.

The above-described measurement is performed by measuring five sites per sample, calculating the density (number per unit area (μm$^2$)) of projections at each site, determining the average value of the obtained five numerical values, and defining this value as the density of the projections defined in the support for a lithographic printing plate according to the embodiment of the present invention. In the present invention, this numerical value may be in the above-described range (3,000 to 9,000 pc/mm$^2$).

The ratio (density/average value of equivalent circular diameters) of the density of projections with a height that is 0.5 μm or greater than the position of projections with the average height to the average value of the equivalent circular diameters is not particularly limited, but is preferably 500 (pc/mm$^2$)/μm or greater and more preferably in a range of 800 to 1,500 (pc/mm$^2$)/μm from the viewpoint that the effects of the present invention are more excellent.

In the support for a lithographic printing plate according to the embodiment of the present invention, a surface area ratio ΔS calculated according to Equation (1), from a geometrically measured area S0 and an actual area Sx determined by an approximate three-point method from three-dimensional data obtained by measuring 512 × 512 points with an area of 25 μm × 25 μm on the surface on the side of the anodized film using an atomic force microscope, is preferably 20% or greater, more preferably 30% or greater, and still more preferably 37% or greater from the viewpoint that the effects of the present invention are more excellent. The upper limit of the surface area ratio ΔS is not particularly limited, but is preferably 70% or less and more preferably 60% or less.

$$\Delta S = (Sx - S0)/S0 \times 100\ (\%) \cdots (1)$$

In the present invention, the surface area ratio ΔS denotes a value measured as follows.

Specifically, the support for a lithographic printing plate is cut into a size of 1 $cm^2$ and set on a horizontal sample stand that is provided on a piezo scanner, a cantilever is allowed to approach the surface of the sample, the surface is scanned in an XY direction in a case where the cantilever reaches a region where an atomic force works, and the unevenness of the sample is captured by the displacement of the piezo in a Z direction. A piezo scanner capable of performing scanning a distance of 150 μm in the XY direction and a distance of 10 μm in the Z direction is used as the piezo scanner. The measurement is performed using a cantilever having a resonance frequency of 130 kHz to 200 kHz and a spring constant of 7 to 20 N/m (OMCL-AC200-TS, manufactured by Olympus Corporation) in a dynamic force mode (DFM). Further, by carrying out the least squares approximation of the acquired three-dimensional data, the slight inclination of the sample is corrected to acquire a reference surface.

During the measurement, 512 × 512 points in an area of 25 × 25 μm on the surface are measured. The surface area ratio is acquired by setting the resolution in the X direction to 0.05 μm, the resolution in the Y direction to 1.9 μm, the resolution in the Z direction to 1 nm, and the scan speed to 18 μm/sec.

Hereinafter, each member of the support for a lithographic printing plate will be described in detail.

[Aluminum plate]

The aluminum plate 12 is made of a metal containing dimensionally stable aluminum as a main component and consists of aluminum or an aluminum alloy. Examples of the aluminum plate 12 include a pure aluminum plate, an alloy plate containing aluminum as a main component and a trace amount of foreign elements, and a plastic film or paper formed by laminating or depositing aluminum (alloy).

Examples of the foreign elements contained in the aluminum alloy include a silicon element, an iron element, a manganese element, a copper element, a magnesium element, a chromium element, a zinc element, a bismuth element, a nickel element, and a titanium element, and the content of the foreign elements in the alloy is 10% by mass or less. As the aluminum plate 12, a pure aluminum plate is suitable, but completely pure aluminum is difficult to produce in terms of smelting technology, and thus the aluminum plate may contain a trace amount of foreign elements.

The composition of the aluminum plate 12 is not particularly limited, and publicly known materials can be appropriately used (for example, JIS A 1050, JIS A 1100, JIS A 3103, and JIS A 3005).

Further, the width of the aluminum plate 12 is preferably approximately 400 to 2,000 mm, and the thickness thereof is preferably approximately 0.1 to 0.6 mm. The width and the thickness thereof can be appropriately changed depending on the size of the printing press, the size of the printing plate, and the user's desire.

[Anodized film]

The anodized film 14A is a film to be prepared typically on a surface of the aluminum plate 12 by performing an anodization treatment. Although not illustrated in Figs. 1 and 2, it is preferable that this film has ultra-fine micropores substantially perpendicular to the surface of the film and individually uniformly distributed. The micropores extend in the thickness direction (the side of the aluminum plate 12) from the surface of the anodized film 14A.

Further, the term "micropores" here is a general term used to indicate pores in the anodized film and does not specify the size of the pore.

The amount of the anodized film is not particularly limited, but is preferably 2.0 $g/m^2$ or greater, more preferably 3.2 $g/m^2$ or greater, and still more preferably 3.4 $g/m^2$ or greater from the viewpoint that the effects of the present invention are more excellent. The upper limit thereof is not particularly limited, but is 5.0 $g/m^2$ or less in many cases and 4.0 $g/m^2$ or less in more cases.

The density of the micropores in the anodized film 14A is not particularly limited, but is preferably in a range of 300 to 2,000 pc/$\mu m^2$ and more preferably in a range of 500 to 1,200 pc/$\mu m^2$ from the viewpoint that the effects of the present invention are more excellent.

The density of micropores is a value obtained by observing 4 sheets (N = 4) of the surfaces of the anodized films 14A using a field emission scanning electron microscope (FE-SEM) at a magnification of 150,000, measuring the number of micropores present in an area of 400 × 600 $nm^2$ in the obtained four sheets of images, and calculating the density of each image, and averaging the calculated values.

The average diameter (average opening diameter) of the micropores in the surface of the anodized film 14A is preferably in a range of 10 to 150 nm and more preferably in a range of 10 to 100 nm. Among these, from the viewpoint of the printing durability, the average diameter thereof is still more preferably in a range of 15 to 100 nm, particularly preferably in a range of 15 to 60 nm, more particularly preferably in a range of 20 to 50 nm, and most preferably in a range of 25 to 40 nm. The same effects can be obtained regardless of whether the inner diameter of the micropores is greater or less than that of the surface layer.

The average diameter of micropores is obtained by observing 4 sheets (N = 4) of the surfaces of the anodized film 14A using a field emission scanning electron microscope (FE-SEM) at a magnification of 150,000, measuring the

diameters of micropores present in an area of 400 × 600 $nm^2$ in the obtained four sheets of images, and averaging the values.

Further, in a case where the shape of the micropores is not circular, the equivalent circular diameter is used. The term "equivalent circular diameter" denotes a diameter of a circle obtained by assuming the shape of an opening portion as a circle having the same projected area as the projected area of the opening portion.

The depth of the micropores is not particularly limited, but is preferably in a range of 10 nm to 3,000 nm, more preferably in a range of 50 nm to 2,000 nm, and still more preferably 300 nm to 1,600 nm.

Further, the depth thereof is a value obtained by capturing (150,000 times) an image of a cross section of the anodized film 14A, measuring the depth of 25 or more micropores, and averaging the obtained values.

The shape of the micropores is not particularly limited, and the micropores may have a substantially straight tubular shape (substantially columnar shape) or a conical shape whose diameter decreases in the depth direction (thickness direction). Further, a shape in which pores having different sizes of diameters in the thickness direction communicate with each other may be employed as described below.

Further, the shape of the bottom portions of the micropores is not particularly limited, and may be a curved (convex) or planar.

The shape of the micropores in the anodized film is not particularly limited, and for example, as illustrated in Fig. 4, a form in which an anodized film 14B has micropores 20 formed of large-diameter pore portions 22 and small-diameter pore portions 24 may be employed.

The micropores 20 in the anodized film 14B are formed of large-diameter pore portions 22 extending to a position at a depth (depth D: see Fig. 4) of 10 to 1,000 nm from the surface of the anodized film 14B and small-diameter pore portions 24 communicating with the bottom portions of large-diameter pore portions 22 and extending to a position at a depth of 20 to 2,000 nm from the communication positions.

Hereinafter, the large-diameter pore portions 22 and the small-diameter pore portions 24 will be described in detail.

The average diameter of the large-diameter pore portions 22 in the surface of the anodized film 14B is the same as the average diameter of the micropores in the surface of the anodized film 14A described above, and is preferably in a range of 10 to 100 nm, and from the viewpoint of the printing durability, more preferably in a range of 18 to 60 nm, still more preferably in a range of 20 to 50 nm, and even still more preferably in a range of 25 to 40 nm.

A method of measuring the average diameter of the large-diameter pore portions 22 in the surface of the anodized film 14B is the same as the method of measuring the average diameter of the micropores in the surface of the anodized film 14A.

The bottom portions of the large-diameter pore portions 22 are positioned at a depth of 10 to 1,000 nm (hereinafter, also referred to as a depth D) from the surface of the anodized film 14B. That is, the large-diameter pore portions 22 are pores extending from the surface of the anodized film 14B to a position at a depth of 10 nm to 1,000 nm in the depth direction (thickness direction). The depth described above is preferably in a range of 10 to 200 nm.

Further, the depth thereof is a value obtained by capturing (at a magnification of 150,000) an image of a cross section of the anodized film 14B, measuring the depth of 25 or more large-diameter pore portions 22, and averaging the obtained values.

The shape of the large-diameter pore portions 22 is not particularly limited, and examples thereof include a substantially straight tubular shape (substantially columnar shape) and a conical shape whose diameter decreases in the depth direction (thickness direction). Among these, a substantially straight tubular shape is preferable.

The small-diameter pore portions 24, as illustrated in Fig. 4, are pores communicating with the bottom portions of the large-diameter pore portions 22 and further extending from the communication positions to the depth direction (thickness direction).

The average diameter of the small-diameter pore portions 24 at the communication positions is less than the average diameter of the large-diameter pore portions and is preferably 15 nm or less. Particularly, the average diameter thereof is more preferably 13 nm or less. The lower limit thereof is not particularly limited, but is 5 nm or greater in many cases.

The average diameter of small-diameter pore portions 24 is obtained by observing 4 sheets (N = 4) of the surfaces of the anodized film 14A using a FE-SEM at a magnification of 150000, measuring the diameters of 50 micropores (small-diameter pore portions) present in an area of 400 × 600 $nm^2$ in the obtained four sheets of images, and averaging the values. Further, in a case where the depth of the large-diameter pore portions is large, the average diameter of the small-diameter pore portions 24 may be acquired by cutting the upper portion (region where large-diameter pore portions are present) of the anodized film 14B (for example, cutting the portion by argon gas) as necessary and observing the surface of the anodized film 14B using the above-described FE-SEM.

Further, in a case where the shape of the small-diameter pore portions 24 is not circular, the equivalent circular diameter is used. The term "equivalent circular diameter" denotes a diameter of a circle obtained by assuming the shape of an opening portion as a circle having the same projected area as the projected area of the opening portion.

The bottom portions of the small-diameter pore portions 24 are in positions extending from the communication positions with the large-diameter pore portions 22 to a depth of 20 to 2,000 nm in the depth direction. In other words, the small-diameter pore portions 24 are pores extending from the communication position with the large-diameter pore portions 22 to the depth direction (thickness direction), and the depth of the small-diameter pore portions 24 is in a range of 20 to 2,000 nm. Further, the depth described above is preferably in a range of 500 to 1,500 nm.

In addition, the depth thereof is a value obtained by capturing (50,000 times) an image of a cross section of the anodized film 14B, measuring the depth of 25 or more small-diameter pore portions 24, and averaging the obtained values.

The shape of the small-diameter pore portions 24 is not particularly limited, and examples thereof include a substantially straight tubular shape (substantially columnar shape) and a conical shape whose diameter decreases in the depth direction. Among these, a substantially straight tubular shape is preferable.

Further, for example, as illustrated in Fig. 5, an anodized film 14C may be in the form of having micropores 30 formed of upper pore portions 32 and lower pore portions 34.

The micropores 30 in the anodized film 14C are formed of the upper pore portions 32 extending in the depth direction from the surface of the anodized film 14C and the lower pore portions 34 communicating with the bottom portions of the upper pore portions 32 and extending to a position at a depth of 20 to 2,000 nm from the communication positions. The upper pore portions 32 consist of small-diameter upper pore portions 36 extending in the depth direction from the surface of the anodized film 14C and large-diameter upper pore portions 38 communicating the bottom portions of the small-diameter upper pore portions 36 and further extending in the depth direction.

The average diameter of the upper pore portions 32 in the surface of the anodized film 14C is the same as the average diameter of the micropores in the surface of the anodized film 14A described above, and is preferably in a range of 10 to 100 nm, and from the viewpoint of the printing durability, more preferably in a range of 18 to 60 m, still more preferably in a range of 20 to 50 nm, even still more preferably in a range of 25 to 40 nm, and particularly preferably in a range of 25 to 40 nm.

A method of measuring the average diameter of the upper pore portions 32 in the surface of the anodized film 14C is the same as the method of measuring the average diameter of the micropores in the surface of the anodized film 14A.

The maximum diameter of the upper pore portions 32 is not particularly limited, but is preferably 200 nm or less and more preferably in a range of 50 to 150 nm from the viewpoint of the printing durability.

Further, the ratio of the maximum diameter of the upper pore portions to the average diameter of the upper pore portions 32 in the surface of the anodized film 14C is not particularly limited, but is preferably 1.2 or greater and more preferably in a range of 2.0 to 6.0 from the viewpoint of the printing durability.

Further, as illustrated in Fig. 5, since the upper pore portions 32 are formed of the small-diameter upper pore portions 36 and the large-diameter upper pore portions 38 with an inner diameter greater than that of the small-diameter upper pore portions 36, the maximum diameter of the upper pore portions 32 corresponds to the inner diameter of the large-diameter upper pore portions 38.

The shape of the upper pore portions 32 is not limited to the aspect of Fig. 5, and for example, the upper pore portions 32 may have a shape in which the inner diameter of the pores gradually increases in the depth direction from the average diameter of the pores in the surface of the anodized film 14C.

The lower pore portions 34 are pores communicating with the bottom portions of the upper pore portions 32 and further extending in the depth direction (thickness direction) from the communication positions as illustrated in Fig. 5.

The average diameter of the small-diameter pore portions 24 at the communication positions is less than the average diameter of the large-diameter pore portions and is preferably 15 nm or less. Particularly, the average diameter thereof is more preferably 13 nm or less. The lower limit thereof is not particularly limited, but is 5 nm or greater in many cases.

The average diameter of the lower pore portions 34 is a value obtained by observing 4 sheets (N = 4) of the surfaces of the anodized film 14A using a FE-SEM at a magnification of 150,000, measuring the diameters of 50 micropores (small-diameter pore portions) present in an area of $400 \times 600$ $nm^2$ in the obtained four sheets of images, and averaging the values. Further, in a case where the depth of the large-diameter pore portions is large, the average diameter of the lower pore portions 34 may be determined by cutting the upper portion (region where upper pore portions are present) of the anodized film 14C (for example, cutting the portion by argon gas) as necessary and observing the surface of the anodized film 14C using the above-described FE-SEM.

Further, in a case where the shape of the lower pore portions 34 is not circular, the equivalent circular diameter is used. The term "equivalent circular diameter" denotes a diameter of a circle obtained by assuming the shape of an opening portion as a circle having the same projected area as the projected area of the opening portion.

The bottom portions of the lower pore portions 34 are at a position further extending to a depth of 20 to 2,000 nm in the depth direction from the communication positions with the upper pore portions 32. In other words, the lower pore portions 34 are pores further extending in the depth direction (thickness direction) from the communication positions

with the upper pore portions 32, and the depth of the lower pore portions 34 is in a range of 20 to 2,000 nm. Further, the depth described above is preferably in a range of 500 to 1,500 nm.

Further, the depth thereof is a value obtained by capturing (50,000 times) an image of a cross section of the anodized film 14C, measuring the depth of 25 or more lower pore portions 34, and averaging the obtained values.

The shape of the lower pore portions 34 is not particularly limited, and examples thereof include a substantially straight tubular shape (substantially columnar shape) and a conical shape whose diameter decreases in the depth direction. Among these, a substantially straight tubular shape is preferable.

[Method of producing support for lithographic printing plate]

A method of producing the support for a lithographic printing plate according to the embodiment of the present invention is not particularly limited, but it is preferable that the method includes a hydrochloric acid electrolytic treatment step of performing AC electrolysis on an aluminum plate in a hydrochloric acid treatment liquid which may contain sulfuric acid to prepare a roughened aluminum plate from the viewpoint that a predetermined support for a lithographic printing plate can be efficiently produced. In particular, in a case where the electrolytic treatment is performed in the hydrochloric acid electrolytic treatment step, it is preferable that the electrolytic treatment is performed 10 times or more by providing a predetermined rest time. That is, it is preferable that the number of times of the electrolytic treatment is set to 10 times or more by performing an operation of repeatedly carrying out the electrolytic treatment for a predetermined time and a rest treatment for a predetermined time.

Further, it is preferable that the method of producing the support for a lithographic printing plate according to the embodiment of the present invention includes an anodization treatment step of performing an anodization treatment on the roughened aluminum plate after the hydrochloric acid electrolytic treatment step to form an anodized aluminum film on the aluminum plate.

Further, it is preferable that the method of producing the support for a lithographic printing plate according to the embodiment of the present invention includes a pore-widening treatment step of performing an etching treatment on the aluminum plate, on which the anodized film has been formed after the anodization treatment step, to expand the diameter of micropores in the anodized film.

Hereinafter, each step described above and optional treatments will be described in detail.

<Mechanical roughening treatment>

In the method of producing the support for a lithographic printing plate according to the embodiment of the present invention, a mechanical roughening treatment may be performed before the hydrochloric acid electrolytic treatment step.

As a mechanical roughening treatment method, for example, a wire brush grain method of scratching an aluminum surface with a metal wire, a ball grain method of graining an aluminum surface with a polishing ball and an abrasive, or a brush grain method of graining a surface with a nylon brush and an abrasive described in JP1994-135175A (JP-H6-135175A) and JP1975-040047B (JP-S50-040047B) can be used.

<Hydrochloric acid electrolytic treatment step>

It is preferable that the hydrochloric acid electrolytic treatment step in the method of producing the support for a lithographic printing plate according to the embodiment of the present invention is a hydrochloric acid electrolytic treatment step of performing an electrolytic treatment ten times or more on an aluminum plate in a hydrochloric acid treatment liquid which may contain sulfuric acid by providing a predetermined rest time, and preparing a roughened aluminum plate.

In the present invention, the above-described support for a lithographic printing plate can be efficiently produced by performing the hydrochloric acid electrolytic treatment as described above and the anodization treatment described below.

In a case where the AC electrolysis is performed, it is preferable to perform the AC electrolysis a plurality of times by providing the rest time as described above.

The rest time provided between the times of the AC electrolysis is preferably in a range of 0.3 to 3.0 seconds and more preferably in a range of 0.5 to 1.5 seconds.

The number of times of performing the AC electrolysis is preferably 10 times or more and more preferably 12 times or more. The upper limit thereof is not particularly limited, but is 20 times or less in many cases.

The hydrochloric acid treatment liquid contains hydrochloric acid, and the concentration of hydrochloric acid is preferably in a range of 5 to 30 g/L and more preferably in a range of 10 to 20 g/L.

The hydrochloric acid treatment liquid may contain sulfuric acid. In a case where the hydrochloric acid treatment

liquid contains sulfuric acid, the concentration of sulfuric acid in the hydrochloric acid treatment liquid is preferably 2.0 g/L or less and more preferably 1.5 g/L or less. In a case where the hydrochloric acid treatment liquid contains sulfuric acid, the lower limit of the concentration of sulfuric acid in the hydrochloric acid treatment liquid is not particularly limited and may be greater than 0 g/L.

The hydrochloric acid treatment liquid may contain aluminum ions. In a case where the hydrochloric acid treatment liquid contains aluminum ions, the concentration of the aluminum ions is preferably in a range of 1.0 to 30.0 g/L and more preferably in a range of 5.0 to 20.0 g/L.

In a case where the hydrochloric acid treatment liquid contains sulfuric acid, the ratio of the content of sulfuric acid to the content of hydrochloric acid is preferably 0.1 or less. The lower limit thereof is not particularly limited and may be greater than 0.

The liquid temperature of the hydrochloric acid treatment liquid is not particularly limited, but it is preferably 30°C or lower, more preferably 25°C or lower, and still more preferably 20°C or lower. The lower limit thereof is not particularly limited, but is preferably 5°C or higher and more preferably 10°C or higher.

In the present invention, the sum of the electric quantity (the sum of the electric quantity for the anodic reaction of the aluminum plate at the time at which the hydrochloric acid electrolytic treatment is completed) is preferably 400 $C/dm^2$ or less and more preferably 375 $C/dm^2$ or less. The lower limit of the sum of the electric quantity is not particularly limited, but is preferably 50 $C/dm^2$ or greater and more preferably 100 $C/dm^2$ or greater.

The peak current value of the alternating current waveform is preferably 80 $A/dm^2$ or less and more preferably 70 $A/dm^2$ or less. The peak current value thereof is preferably 10 $A/dm^2$ or greater and more preferably 20 $A/dm^2$ or greater.

The alternating current waveform of the hydrochloric acid electrolytic treatment may use a sine wave, a square wave, a trapezoidal wave, a triangular wave, or the like. The frequency is preferably in a range of 0.1 to 250 Hz.

Fig. 6 is a graph showing an example of an alternating waveform current waveform diagram used for the hydrochloric acid electrolytic treatment.

In Fig. 6, ta represents an anodic reaction time, tc represents a cathodic reaction time, tp represents a time taken for the current to reach the peak from 0, Ia represents the peak current on an anode cycle side, and Ic represents the peak current on a cathode cycle side. In the trapezoidal wave, the time tp taken for the current to reach the peak from 0 is preferably in a range of 1 to 10 msec. As the preferable conditions for one cycle of the alternating current used for the hydrochloric acid electrolytic treatment, a ratio tc/ta of the cathodic reaction time tc to the anodic reaction time ta of the aluminum plate is in a range of 1 to 20, a ratio Qc/Qa of an electric quantity Qc in a case of the aluminum plate serving as an anode to an electric quantity Qa in a case of the aluminum plate serving as an anode is in a range of 0.3 to 20, and the anodic reaction time ta is in a range of 5 to 1,000 msec. It is preferable that the current density is in the above-described range (80 $A/dm^2$ or less) in both the anode cycle side Ia and the cathode cycle side Ic of the current in terms of the peak value of the trapezoidal wave.

A device illustrated in Fig. 7 can be used for the hydrochloric acid electrolytic treatment carried out using the alternating current.

Fig. 7 is a side view illustrating an example of a radial type cell in the hydrochloric acid electrolytic treatment carried out using the alternating current.

In Fig. 7, 50 represents a main electrolytic cell, 51 represents an AC power source, 52 represents a radial drum roller, 53a and 53b represent a main pole, 54 represents an electrolytic liquid feed inlet, 55 represents an electrolytic solution, 56 represents a slit, 57 represents an electrolytic liquid channel, 58 represents an auxiliary anode, 60 represents an auxiliary anode cell, and W represents an aluminum plate. In a case where two or more electrolytic cells are used, the electrolysis conditions may be the same as or different from each other.

The aluminum plate W is wound around the radial drum roller 52 disposed by being immersed in the main electrolytic cell 50 and is subjected to the electrolytic treatment by the main poles 53a and 53b connected to the AC power source 51 in the transport process. The electrolytic solution 55 is supplied to the electrolytic liquid channel 57 disposed between the radial drum roller 52 and the main pole 53a and between the radial drum roller 52 and the main pole 53b through the slit 56 from the electrolytic liquid feed inlet 54. The aluminum plate W which has been treated in the main electrolytic cell 50 is electrolyzed in the auxiliary anode cell 60. The auxiliary anode 58 is disposed in the auxiliary anode cell 60 to face the aluminum plate W and the electrolytic solution 55 is supplied to flow through the space between the auxiliary anode 58 and the aluminum plate W.

<Alkali etching treatment>

In the method of producing the support for a lithographic printing plate according to the embodiment of the present invention, it is preferable that an alkali etching treatment is performed after the mechanical roughening treatment in a case where the above-described mechanical roughening treatment is performed and before and after the above-described hydrochloric acid electrolytic treatment step. Further, the alkali etching treatment may not be performed.

In addition, the alkali etching treatment performed before the hydrochloric acid electrolytic treatment is performed

for the purpose of removing rolling oil, stains, natural oxide films, and the like on the surface of the aluminum plate (rolled aluminum) in a case where the mechanical roughening treatment has not been performed and for the purpose of dissolving edge portions of unevenness generated by the mechanical roughening treatment to change the surface with steep unevenness to a surface with smooth undulations in a case where the mechanical roughening treatment has been performed.

In a case where the mechanical roughening treatment is not performed before the alkali etching treatment, the etching amount is preferably in a range of 0.1 to 10 $g/m^2$ and more preferably in a range of 1 to 5 $g/m^2$. In a case where the etching amount is in a range of 1 to 10 $g/m^2$, rolling oil, stains, natural oxide films, and the like on the surface are sufficiently removed.

In a case where the mechanical roughening treatment is performed before the alkali etching treatment, the etching amount is preferably in a range of 3 to 20 $g/m^2$ and more preferably in a range of 5 to 15 $g/m^2$.

The alkali etching treatment performed immediately after the hydrochloric acid electrolytic treatment is performed for the purpose of dissolving smut generated in an acidic electrolytic solution and dissolving edge portions of unevenness formed by the hydrochloric acid electrolytic treatment. Since the unevenness formed by the hydrochloric acid electrolytic treatment varies depending on the kind of the electrolytic solution, the optimum etching amount also varies, and the etching amount in a case where the alkali etching treatment is performed after the hydrochloric acid electrolytic treatment is preferably greater than 0 $g/m^2$ and 0.50 $g/m^2$ or less, more preferably greater than 0 $g/m^2$ and 0.30 $g/m^2$ or less, and from the viewpoint that the printing durability is more excellent, still more preferably greater than 0 $g/m^2$ and 0.20 $g/m^2$ or less.

Examples of the alkali used in the alkaline solution include caustic alkali and an alkali metal salt. In particular, an aqueous solution of caustic soda is preferable.

The concentration of the alkaline solution can be determined depending on the etching amount, but is preferably in a range of 1% to 50% by mass and more preferably in a range of 10% to 35% by mass. In a case where aluminum ions are dissolved in the alkaline solution, the concentration of the aluminum ions is preferably in a range of 0.01% to 10% by mass and more preferably in a range of 3% to 8% by mass. The temperature of the alkaline solution is preferably in a range of 20°C to 90°C. The treatment time is preferably in a range of 0 to 120 seconds.

Examples of a method of bringing the aluminum plate into contact with the alkaline solution include a method of causing the aluminum plate to pass through a tank containing the alkaline solution, a method of immersing the aluminum plate in a tank containing the alkaline solution, and a method of spraying the alkaline solution onto the surface of the aluminum plate.

<Desmutting treatment>

In the method of producing the support for a lithographic printing plate according to the embodiment of the present invention, it is preferable that acid washing (desmutting treatment) is performed to remove corrosive organisms remaining on the surface after the hydrochloric acid electrolytic treatment or the alkali etching treatment is performed.

As the acid to be used, for example, nitric acid, sulfuric acid, hydrochloric acid, or the like is commonly used, but other acids may be used.

The desmutting treatment is performed, for example, by bringing the aluminum plate into contact with an acidic solution (containing 0.01% to 5% by mass of aluminum ions) in which the concentration of hydrochloric acid, nitric acid, sulfuric acid, or the like is in a range of 0.5% to 30% by mass.

Examples of a method of bringing the aluminum plate into contact with the acidic solution include a method of causing the aluminum plate to pass through a tank containing the acidic solution, a method of immersing the aluminum plate in a tank containing the acidic solution, and a method of spraying the acidic solution onto the surface of the aluminum plate.

Since the surface state of the aluminum plate after the desmutting treatment affects the subsequent growth of natural oxide films, the kind of the acid, the concentration, and the temperature conditions are appropriately selected depending on the purpose thereof.

<Water washing treatment>

In the method of producing the support for a lithographic printing plate according to the embodiment of the present invention, it is preferable to perform washing with water after completion of each of the treatment steps described above. In particular, washing with water at the end of the step affects the subsequent growth of natural oxide films, and thus washing with water is required to be sufficiently performed using pure water, well water, tap water, or the like.

<Anodization treatment step>

The above-described anodization treatment step is a step of performing an anodization treatment on the roughened aluminum plate after the hydrochloric acid electrolytic treatment step to form an anodized aluminum film on the aluminum plate.
Here, the procedure of the anodization treatment step is not particularly limited, and examples thereof include known methods.
In the anodization treatment step, an aqueous solution containing sulfuric acid, phosphoric acid, oxalic acid, or the like can be used as an electrolytic cell. For example, the concentration of the sulfuric acid is in a range of 0.1 to 300 g/L.
The conditions for the anodization treatment are appropriately set depending on the electrolytic solution. As an example of the conditions, the liquid temperature is in a range of 5 to 70°C (preferably in a range of 10 to 60°C), the current density is in a range of 0.5 to 60 $A/dm^2$ (preferably in a range of 5 to 60 $A/dm^2$), the voltage is in a range of 1 to 100 V (preferably in a range of 5 to 50 V), the electrolysis time is in a range of 1 to 100 seconds (preferably in a range of 5 to 60 seconds), and the film amount is in a range of 0.1 to 5 $g/m^2$ (preferably in a range of 0.2 to 3 $g/m^2$).

<Pore-widening treatment step>

The above-described pore-widening treatment step is a treatment (pore diameter expanding treatment) step of performing an etching treatment on the aluminum plate, on which the anodized film has been formed after the anodization treatment step described above, to expand the diameter of micropores in the anodized film.
The pore-widening treatment can be performed by bringing the aluminum plate obtained in the above-described anodization treatment step into contact with an acid aqueous solution or an alkaline aqueous solution. The method of bringing the aluminum plate into contact with the solution is not particularly limited, and examples thereof include an immersion method and a spray method.
Further, a method of producing the anodized film 14B illustrated in Fig. 4 described above is not particularly limited, but a production method of sequentially performing the following steps is preferable.

(Hydrochloric acid electrolytic treatment step) A step of performing the above-described hydrochloric acid electrolytic treatment on the aluminum plate
(First anodization treatment step) A step of anodizing the aluminum plate which has been subjected to the roughening treatment
(Pore-widening treatment step) A step of expanding the diameters of micropores in the anodized film by bringing the aluminum plate having the anodized film obtained in the first anodization treatment step into contact with an acid aqueous solution or an alkaline aqueous solution
(Second anodization treatment step) A step of anodizing the aluminum plate obtained by the pore-widening treatment step

As the procedures of each step, known methods can be referred to.
Further, a method of producing the anodized film 14C illustrated in Fig. 5 is not particularly limited, and examples thereof include a method of performing the anodization treatment three times.

[Lithographic printing plate precursor]

A lithographic printing plate precursor according to the embodiment of the present invention includes the above-described support for a lithographic printing plate.
More specifically, a lithographic printing plate precursor 40 illustrated in Fig. 8 includes a support 42 for a lithographic printing plate and an image recording layer 46 disposed on the support 42 for a lithographic printing plate, and it is preferable that an undercoat layer 44 is provided between the support 42 for a lithographic printing plate and the image recording layer 46 as illustrated in Fig. 8. The undercoat layer 44 is an optional member.
The configuration of the support 42 for a lithographic printing plate is as described above, and the anodized film in the support 42 for a lithographic printing plate is disposed on a side of the image recording layer.
Hereinafter, other members in the lithographic printing plate precursor will be described in detail.

[Undercoat layer]

The undercoat layer 44 is a layer disposed between the support 42 for a lithographic printing plate and the image recording layer 46 and improves the adhesiveness between the support and the image recording layer. As

described above, the undercoat layer 44 is a layer provided as necessary and may not be provided in the lithographic printing plate precursor.

The configuration of the undercoat layer is not particularly limited, but it is preferable that the undercoat layer contains polyvinylphosphonic acid from the viewpoint of suppressing ink adhesiveness in a non-image area while maintaining printing durability.

Here, as the polyvinylphosphonic acid, those disclosed in US3276868A, US4153461A, and US4689272A can be used.

The configuration of the undercoat layer is not particularly limited, but it is preferable that the undercoat layer contains a compound having a betaine structure from the viewpoint that the stain resistance and deinking capability after being left to stand are satisfactory.

Here, the betaine structure denotes a structure having at least one cation and at least one anion. Further, the number of cations is typically the same as the number of anions to be neutral as a whole. However, according to the present invention, in a case where the number of cations is not the same as the number of anions, the charge is cancelled by having a required amount of counter ions so that the betaine structure is obtained.

It is preferable that the betaine structure is any of the structures represented by Formulae (1), (2), and (3).

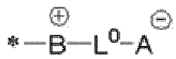
Formula (1)

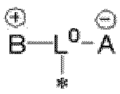
Formula (2)

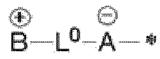
Formula (3)

In the formulae, $A^-$ represents a structure having an anion, $B^+$ represents a structure having a cation, and $L^0$ represents a linking group. The symbol "*" represents a linking site (linking position).

It is preferable that $A^-$ represents a structure having an anion such as a carboxylate, a sulfonate, a phosphonate, or a phosphinate and $B^+$ represents a structure having a cation such as ammonium, phosphonium, iodonium, or sulfonium.

$L^0$ represents a linking group. In Formulae (1) and (3), examples of $L^0$ include divalent linking groups. Among these, -CO-, -O-, -NH-, a divalent aliphatic group, a divalent aromatic group, or a combination thereof is preferable. In Formula (2), examples of $L^0$ include trivalent linking groups.

A linking group having 30 or less carbon atoms including the number of carbon atoms of the following substituent which may be included is preferable as the linking group.

Specific examples of the linking group include an alkylene group (having preferably 1 to 20 carbon atoms and more preferably 1 to 10 carbon atoms) and an arylene group (having preferably 5 to 15 carbon atoms and more preferably 6 to 10 carbon atoms) such as a phenylene group or a xylylene group.

Further, these linking groups may further have substituents.

Examples of the substituent include a halogen atom, a hydroxyl group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group, and a diarylamino group.

From the viewpoint that at least one of the printing durability, the stain resistance, the deinking capability after being left to stand, or the image visibility is more excellent, a structure represented by Formula (i), (ii), or (iii) is preferable, and a structure represented by Formula (i) is more preferable as the betaine structure. The symbol "*" represents a linking site.

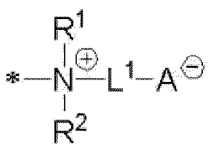
( i )

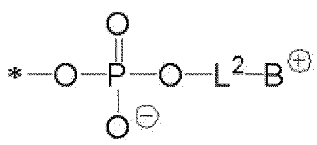
( ii )

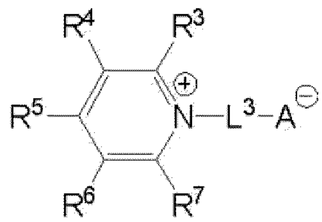
( iii )

In Formula (i), $R^1$ and $R^2$ each independently represent a hydrogen atom, an alkyl group, an alkenyl group, an alkynyl group, an aryl group, or a heterocyclic group, and $R^1$ and $R^2$ may be linked to each other to form a ring structure.

The ring structure may have heteroatoms such as an oxygen atom. As the ring structure, a 5- to 10-membered ring is preferable and a 5- or 6-membered ring is more preferable.

The number of carbon atoms in $R^1$ and $R^2$ is preferably in a range of 1 to 30 and more preferably in a range of 1 to 20.

It is preferable that $R^1$ and $R^2$ represent a hydrogen atom, a methyl group, or an ethyl group.

$L^1$ represents a divalent linking group and preferably -CO-, -O-, -NH-, a divalent aliphatic group (such as an alkylene group), a divalent aromatic group (such as a phenylene group), or a combination thereof.

It is preferable that $L^1$ represents a linear alkylene group having 3 to 5 carbon atoms.

In Formula (i), $A^-$ represents a structure having an anion and preferably a carboxylate, a sulfonate, a phosphonate, or a phosphinate.

Specific examples thereof include the following structures.

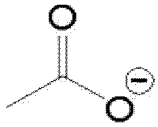
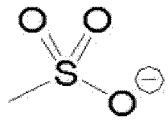
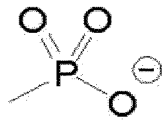
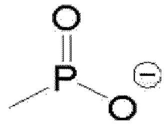

In Formula (i), a combination in which $L^1$ represents a linear alkylene group having 4 or 5 carbon atoms and $A^-$ represents a sulfonate is preferable, and a combination in which $L^1$ represents a linear alkylene group having 4 carbon atoms and $A^-$ represents a sulfonate is more preferable.

In Formula (ii), $L^2$ represents a divalent linking group and preferably -CO-, -O-, -NH-, a divalent aliphatic group (such as an alkylene group), a divalent aromatic group (such as a phenylene group), or a combination thereof.

$B^+$ represents a structure having a cation and preferably a structure having ammonium, phosphonium, iodonium, or sulfonium. Among these, a structure having ammonium or phosphonium is preferable, and a structure having ammonium is more preferable.

Examples of the structure having a cation include a trimethylammonio group, a triethylammonio group, a tributylammonio group, a benzyldimethylammonio group, a diethylhexylammonio group, a (2-hydroxyethyl)dimethylammonio group, a pyridinio group, a N-methylimidazolio group, a N-acridinio group, a trimethylphosphonio group, a triethylphosphonio group, and a triphenylphosphonio group.

In Formula (iii), $L^3$ represents a divalent linking group and preferably -CO-, -O-, -NH-, a divalent aliphatic group (such as an alkylene group), a divalent aromatic group (such as a phenylene group), or a combination thereof.

$A^-$ represents a structure having an anion and preferably a carboxylate, a sulfonate, a phosphonate, or a phosphinate. Further, the details and preferred examples thereof are the same as those for $A^-$ in Formula (i).

$R^3$ to $R^7$ each independently represent a hydrogen atom or a substituent (having preferably 1 to 30 carbon atoms), and at least one of $R^3$, ..., or $R^7$ represents a linking site.

At least one of $R^3$, ..., or $R^7$ as a linking site may be linked to another site in the compound through a substituent as at least one of $R^3$, ..., or $R^7$ or may be directly linked to another site in the compound through a single bond.

Examples of the substituents represented by $R^3$ to $R^7$ include a halogen atom, an alkyl group, (such as a cycloalkyl group or a bicycloalkyl group), an alkenyl group (such as a cycloalkenyl group or a bicycloalkenyl group), an alkynyl group, an aryl group, a heterocyclic group, a cyano group, a hydroxyl group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (such as an anilino group), an acylamino group, an aminocarbonylamino group, an alkoxycarbonylamino group, an aryloxycarbonylamino group, a sulfamoylamino group, an alkyl and arylsulfonylamino group, a mercapto group, an alkylthio group, an arylthio group, a heterocyclic thio group, a sulfamoyl group, a sulfo group, an alkyl and arylsulfinyl group, an alkyl and arylsulfonyl group, an acyl group, an aryloxycarbonyl group, an alkoxycarbonyl group, a carbamoyl group, an aryl and heterocyclic azo group, an imide group, a phosphino group, a phosphinyl group, a phosphinyloxy group, a phosphinylamino group, and a silyl group.

It is preferable that the compound is a polymer having a repeating unit with a betaine structure (hereinafter, also simply referred to as "specific polymer"). As the repeating unit with a betaine structure, a repeating unit represented by Formula (A1) is preferable.

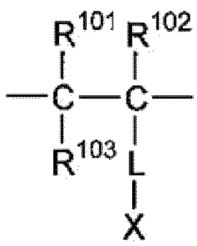
(A1)

In the formula, $R^{101}$ to $R^{103}$ each independently represent a hydrogen atom, an alkyl group, or a halogen atom. L represents a single bond or a divalent linking group.

Examples of the divalent linking group include -CO-, -O-, -NH-, a divalent aliphatic group, a divalent aromatic group, and a combination thereof.

Specific examples of L formed of the above-described combination are listed below. In each of the following examples, the left side is bonded to the main chain and the right side is bonded to X.

L1: -CO-O-divalent aliphatic group-
L2: -CO-O-divalent aromatic group-
L3: -CO-NH-divalent aliphatic group-
L4: -CO-NH-divalent aromatic group-
L5: -CO-divalent aliphatic group-
L6: -CO-divalent aromatic group-
L7: -CO-divalent aliphatic group-CO-O-divalent aliphatic group-
L8: -CO-divalent aliphatic group-O-CO-divalent aliphatic group-
L9: -CO-divalent aromatic group-CO-O-divalent aliphatic group-
L10: -CO-divalent aromatic group-O-CO-divalent aliphatic group-
L11: -CO-divalent aliphatic group-CO-O-divalent aromatic group-
L12: -CO-divalent aliphatic group-O-CO-divalent aromatic group-
L13: -CO-divalent aromatic group-CO-O-divalent aromatic group-
L14: -CO-divalent aromatic group-O-CO-divalent aromatic group-
L15: -CO-O-divalent aromatic group-O-CO-NH-divalent aliphatic group-
L16: -CO-O-divalent aliphatic group-O-CO-NH-divalent aliphatic group-

Examples of the divalent aliphatic group include an alkylene group, an alkenylene group, and an alkynylene group.

Examples of the divalent aromatic group include an aryl group. Further, a phenylene group or a naphthylene group is preferable.

X represents a betaine structure. It is preferable that X represents a structure represented by Formula (i), Formula (ii), or Formula (iii).

Particularly, in Formula (A1), a combination in which L represents L1 or L3, X represents a structure represented by Formula (i), and $A^-$ in Formula (i) represents a sulfonate group is preferable.

The content of the repeating unit having a betaine structure in the specific polymer is not particularly limited, but is in a range of 20% to 95% by mass in many cases, preferably in a range of 50% to 95% by mass, and more preferably in a range of 60% to 90% by mass with respect to all repeating units constituting the specific polymer.

The specific polymer may have repeating units other than the repeating unit having a betaine structure.

The specific polymer may have a repeating unit having a structure that interacts with the surface of the support for a lithographic printing plate (hereinafter, also simply referred to as "interaction structure").

Examples of the interaction structure include a carboxylic acid structure, a carboxylate structure, a sulfonic acid structure, a sulfonate structure, a phosphonic acid structure, a phosphonate structure, a phosphoric acid ester structure, a phosphoric acid ester salt structure, a β-diketone structure, and a phenolic hydroxyl group, and examples thereof also include structures represented by the following formulae. Among these, a carboxylic acid structure, a carboxylate structure, a sulfonic acid structure, a sulfonate structure, a phosphonic acid structure, a phosphonate structure, a phosphoric acid ester structure, or a phosphoric acid ester salt structure is preferable.

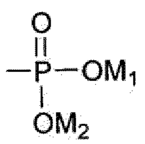
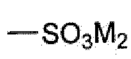
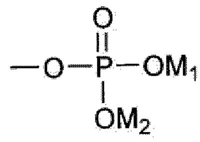
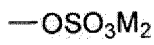

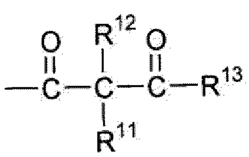
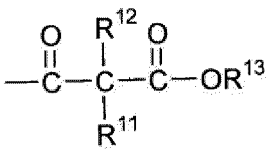
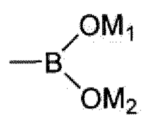
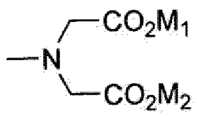

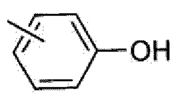

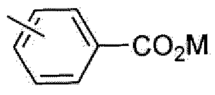

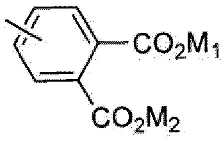

In the formulae, $R^{11}$ to $R^{13}$ each independently represent a hydrogen atom, an alkyl group, an aryl group, an alkynyl group, or an alkenyl group, and M, $M_1$, and $M_2$ each independently represent a hydrogen atom, a metal atom (such as an alkali metal atom such as Na or Li), or an ammonium group. B represents a boron atom.

As the repeating unit having an interaction structure, a repeating unit represented by Formula (A2) is preferable.

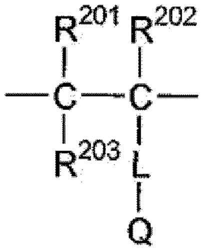

(A2)

In the formula, $R^{201}$ to $R^{203}$ each independently represent a hydrogen atom, an alkyl group (having preferably 1 to 6 carbon atoms), or a halogen atom.

L represents a single bond or a divalent linking group. Examples of the divalent linking group include -CO-, -O-, -NH-, a divalent aliphatic group, a divalent aromatic group, and a combination thereof.

Specific examples of L formed of the above-described combination include the same structures for Formula (A1), and L17 and L18.

L17: -CO-NH-

L18: -CO-O-

Among L1 to L18, L1 to L4, L17, or L18 is preferable.

Q represents an interaction structure, and the preferable aspect thereof is the same as described above.

The content of the repeating unit having the interaction structure in the specific polymer is not particularly limited, but is preferably in a range of 1% to 40% by mass and more preferably in a range of 3% to 30% by mass with respect to all repeating units constituting the specific polymer.

The specific polymer may have a repeating unit that contains a radically polymerizable reactive group.

Examples of the radically polymerizable reactive group include an addition-polymerizable unsaturated bonding group (such as a (meth)acryloyl group, a (meth)acrylamide group, a (meth)acrylonitrile group, an allyl group, a vinyl group, a vinyloxy group, or an alkynyl group) and a functional group capable of chain transfer (such as a mercapto group).

The specific polymer having a repeating unit that contains a radically polymerizable reactive group can be obtained by introducing a radically polymerizable reactive group using the method described in JP2001-312068A. Excellent developability is exhibited in an unexposed portion, the permeability of the developer is suppressed by the polymerization in an exposed portion, and the adhesion property and the adhesiveness between the support for a lithographic printing plate and the image recording layer are further improved, by using the specific polymer having a repeating unit that contains a radically polymerizable reactive group.

The content of the repeating unit that contains a radically polymerizable reactive group in the specific polymer is not particularly limited, but is preferably in a range of 1% to 30% by mass and more preferably in a range of 3% to 20% by mass with respect to the total amount of all repeating units constituting the specific polymer.

The content of the compound having a betaine structure in the undercoat layer 44 is not particularly limited, but is preferably 80% by mass or greater and more preferably 90% by mass or greater with respect to the total mass of the undercoat layer. The upper limit thereof is, for example, 100% by mass.

Hereinbefore, the undercoat layer that contains a compound with a betaine structure has been described, but the undercoat layer may contain another compound.

For example, the undercoat layer may contain a compound that contains a hydrophilic group. Examples of the hydrophilic group include a carboxylic acid group and a sulfonic acid group.

The compound that contains a hydrophilic group may further contain a radically polymerizable reactive group.

[Image recording layer]

As an image recording layer 46, an image recording layer which can be removed by a printing ink and/or dampening water is preferable.
Hereinafter, each constituent component of the image recording layer 46 will be described.

<Infrared absorber>

It is preferable that the image recording layer 46 contains an infrared absorber.
It is preferable that the infrared absorber has a maximum absorption wavelength at a wavelength range of 750 to 1,400 nm. Particularly, since on-press development is carried out by a printing press under white light in an on-press development type lithographic printing plate precursor, a lithographic printing plate precursor with excellent developability can be obtained by using an infrared absorber having a maximum absorption wavelength at a wavelength range of 750 to 1,400 nm, which is not easily affected by the white light.
A dye or a pigment is preferable as the infrared absorber.
As the dye, commercially available dyes and known dyes described in the literatures, for example, "Dye Handbook" (edited by The Society of Synthetic Organic Chemistry, Japan, published in 1970) are exemplified.
Specific examples of the dye include a cyanine coloring agent, a squarylium coloring agent, a pyrylium salt, a nickel thiolate complex, and an indolenine cyanine coloring agent. Among these, a cyanine coloring agent or an indolenine cyanine coloring agent is preferable, a cyanine coloring agent is more preferable, and a cyanine coloring agent represented by Formula (a) is still more preferable.

Formula (a)

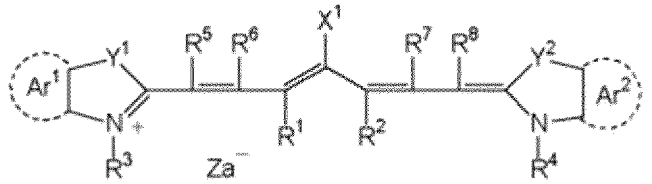

In Formula (a), $X^1$ represents a hydrogen atom, a halogen atom, $-N(R^9)(R^{10})$, $-X^2-L^1$, or a group shown below.

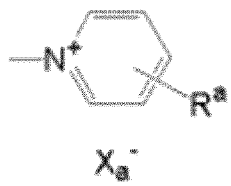

$R^9$ and $R^{10}$ each independently represent an aromatic hydrocarbon group, an alkyl group, or a hydrogen atom, and $R^9$ and $R^{10}$ may be bonded to each other to form a ring. Among these, a phenyl group is preferable.
$X^2$ represents an oxygen atom or a sulfur atom, and $L^1$ represents a hydrocarbon group having 1 to 12 carbon atoms which may have heteroatoms (such as N, S, O, a halogen atom, and Se).
$X_a^-$ has the same definition as that for $Z_a^-$ described below, and $R^a$ represents a hydrogen atom, an alkyl group, an aryl group, an amino group, or a halogen atom.
$R^1$ and $R^2$ each independently represent a hydrocarbon group having 1 to 12 carbon atoms. Further, $R^1$ and $R^2$ may be bonded to each other to form a ring, and it is preferable that a 5- or 6-membered ring is formed during the formation of a ring.
$Ar^1$ and $Ar^2$ each independently represent an aromatic hydrocarbon group which may have a substituent (for example, an alkyl group). As the aromatic hydrocarbon group, a benzene ring group or a naphthalene ring group is preferable.
$Y^1$ and $Y^2$ each independently represent a sulfur atom or a dialkyl methylene group having 12 or less carbon atoms.
$R^3$ and $R^4$ each independently represent a hydrocarbon group having 20 or less carbon atoms which may have a substituent (such as an alkoxy group).

$R^5$, $R^6$, $R^7$, and $R^8$ each independently represent a hydrogen atom or a hydrocarbon group having 12 or less carbon atoms.

Further, $Za^-$ represents a counter anion. Here, $Za^-$ is not necessary in a case where the cyanine coloring agent represented by Formula (a) has an anionic substituent in the structure thereof and neutralization of the charge is not required. Examples of $Za^-$ include a halide ion, a perchlorate ion, a tetrafluoroborate ion, a hexafluorophosphate ion, and a sulfonate ion. Among these, a perchlorate ion, a hexafluorophosphate ion, or an arylsulfonate ion is preferable.

The above-described infrared absorbing dyes may be used alone or in combination of two or more kinds thereof. Further, infrared absorbers other than the infrared absorbing dyes such as pigments may be used in combination. As the pigments, the compounds described in paragraphs [0072] to [0076] in JP2008-195018A are preferable.

The content of the infrared absorber is preferably in a range of 0.05% to 30% by mass and more preferably in a range of 0.1% to 20% by mass with respect to the total mass of the image recording layer.

<Polymerization initiator>

It is preferable that the image recording layer 46 contains a polymerization initiator.

As the polymerization initiator, a compound (so-called radical polymerization initiator) that generates a radical using light, heat, or the energy of both light and heat and initiates polymerization of a compound containing a polymerizable unsaturated group is preferable. Examples of the polymerization initiator include a photopolymerization initiator and a thermal polymerization initiator.

As the polymerization initiator, specifically, the polymerization initiators described in paragraphs [0115] to [0141] described in JP2009-255434A can be used.

Further, from the viewpoints of the reactivity and the stability, an oxime ester compound or an onium salt such as a diazonium salt, an iodonium salt, or a sulfonium salt is preferable as the polymerization initiator.

The content of the polymerization initiator is preferably in a range of 0.1% to 50% by mass and more preferably in a range of 0.5% to 30% by mass with respect to the total mass of the image recording layer.

<Polymerizable compound>

It is preferable that the image recording layer 46 contains a polymerizable compound.

As the polymerizable compound, an addition-polymerizable compound having at least one ethylenically unsaturated bond is preferable. Among the examples, a compound having at least one (preferably two) terminal ethylenically unsaturated bond is more preferable. A so-called radically polymerizable compound is more preferable.

Examples of the polymerizable compound include the polymerizable compounds described in paragraphs [0142] to [0163] of JP2009-255434A.

Further, a urethane-based addition-polymerizable compound produced using the addition reaction between isocyanate and a hydroxyl group is also suitable. Specific examples thereof include a vinyl urethane compound containing two or more polymerizable vinyl groups in one molecule which is obtained by adding a vinyl monomer that contains a hydroxyl group represented by Formula (A) to a polyisocyanate compound containing two or more isocyanate groups in one molecule described in JP1973-041708B (JP-S48-041708B).

$$CH_2=C(R^4)COOCH_2CH(R^5)OH \qquad (A)$$

(Here, $R^4$ and $R^5$ represent H or $CH_3$.)

The content of the polymerizable compound is preferably in a range of 3% to 80% by mass and more preferably in a range of 10% to 75% by mass with respect to the total mass of the image recording layer.

<Binder polymer>

It is preferable that the image recording layer 46 further contains a binder polymer.

Examples of the binder polymer include known binder polymers. Specific examples of the binder polymer include an acrylic resin, a polyvinyl acetal resin, a polyurethane resin, a polyurea resin, a polyimide resin, a polyamide resin, an epoxy resin, a methacrylic resin, a polystyrene-based resin, a novolak type phenol-based resin, a polyester resin, synthetic rubber, and natural rubber.

The binder polymer may have crosslinking properties in order to improve coated-film hardness of an image area. In order to allow the binder polymer to have the crosslinking property, a crosslinkable functional group such as an ethylenically unsaturated bond may be introduced to the main chain or a side chain of the polymer. The crosslinkable functional group may be introduced by copolymerization.

As the binder polymer, for example, the binder polymers disclosed in paragraphs [0165] to [0172] of

JP2009-255434A can be used.

The content of the binder polymer is preferably in a range of 5% to 90% by mass and more preferably in a range of 5% to 70% by mass with respect to the total mass of the image recording layer.

<Surfactant>

The image recording layer 46 may contain a surfactant in order to promote the on-press developability in a case of start of printing and improve the state of the coated surface.

Examples of the surfactant include a nonionic surfactant, an anionic surfactant, a cationic surfactant, an amphoteric surfactant, and a fluorine-based surfactant.

As the surfactant, the surfactants disclosed in paragraphs [0175] to [0179] of JP2009-255434A can be used.

The content of the surfactant is preferably in a range of 0.001% to 10% by mass and more preferably in a range of 0.01% to 5% by mass with respect to the total mass of the image recording layer.

<Color forming agent>

The image recording layer 46 contains preferably a color forming agent and more preferably an acid color forming agent.

The term "color forming agent" used in the present disclosure denotes a compound having a property of changing the color of the image recording layer by developing or decoloring the color thereof using stimulation of light, an acid, or the like and the term "acid color forming agent" denotes a compound having a property of changing the color of the image recording layer by heating the layer in a state of accepting an electron-accepting compound (a proton of an acid or the like) so that the layer is color-formed or decolored. As the acid color forming agent, a colorless compound which has a partial skeleton such as a lactone, a lactam, a sultone, a spiropyran, an ester, or an amide and in which these partial skeletons are rapidly ring-opened or cleaved in a case of being brought into contact with an electron-accepting compound is particularly preferable.

Examples of such an acid color forming agent include phthalides such as 3,3-bis(4-dimethylaminophenyl)-6-dimethylaminophthalide (referred to as "crystal violet lactone"), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl)phthalide, 3-(4-dimethylaminophenyl)-3-(2-methylindol-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazol-3-yl)-6-dimethylaminophthalide, 3,3-bis(2-phenylindol-3-yl)-6-dimethylaminophthalide, and 3-(4-dimethylaminophenyl)-3-(1-methylpyrrol-3-yl)-6-dimethylaminophthalide,

3,3-bis[1,1-bis(4-dimethylaminophenyl)ethylene-2-yl]-4,5,6,7-tetrachlorophthalide, 3,3-bis[1,1-bis(4-pyrrolidinophenyl)ethylene-2-yl]-4,5,6,7-tetrabromophthalide, 3,3-bis[1-(4-dimethylaminophenyl)-1-(4-methoxyphenyl)ethylene-2-yl]-4,5,6,7-tetrachloropht halide, 3,3-bis[1-(4-pyrrolidinophenyl)-1-(4-methoxyphenyl)ethylene-2-yl]-4,5,6,7-tetrachlorophthali de, 3-[1,1-di(1-ethyl-2-methylindol-3-yl)ethylene-2-yl]-3-(4-diethylaminophenyl)phthalide, 3-[1,1-di(1-ethyl-2-methylindol-3-yl)ethylene-2-yl]-3-(4-N-ethyl-N-phenylaminophenyl)phtha lide, 3-(2-ethoxy-4-diethylaminophenyl)-3-(1-n-octyl-2-methylindol-3-yl)-phthalide, 3,3-bis(1-n-octyl-2-methylindol-3-yl)-phthalide, and 3-(2-methyl-4-diethylaminophenyl)-3-(1-n-octyl-2-methylindol-3-yl)-phthalide,

4,4-bis-dimethylaminobenzhydrinbenzylether, N-halophenyl-leucoauramine, N-2,4,5-trichlorophenyl leucoauramine, rhodamine-B-anilinolactam, rhodamine-(4-nitroanilino)lactam, rhodamine-B-(4-chloroanilino)lactam, 3,7-bis(diethylamino)-10-benzoylphenoxazine, benzoyl leucomethylene blue, and 4-nitrobenzoyl methylene blue,

fluorans such as 3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluoran, 3-di-n-butylamino-7-(2'-fluorophenylamino)fluoran, 3-di-n-butylamino-7-(2'-chlorophenylamino)fluoran, 3-N-isopentyl-N-ethylamino-7-(2'-chlorophenylamino)fluoran,

3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-piperidino-6-methyl-7-anilinofluoran, 3-morpholino-6-methyl-7-anilinofluoran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-methylamino-6-methyl-7-anilinofluoran, 3-N-isobutyl-N-ethylamino-6-methyl-7-anilinofluoran, 3-N-isopentyl-N-ethylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran,

3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3'-methoxypropyl)-N-methylamino-6-methyl-7-anilinofluoran, 3-N-(3'-methoxypropyl)-N-ethylamino-6-methyl-7-anilinofluoran, 3-N-(3'-ethoxypropyl)-N-methylamino-6-methyl-7-anilinofluoran, 3-N-(3'-ethoxypropyl)-N-ethylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-ethyl-7-anilinofluoran, 3-diethylamino-6-methyl-7-(3'-methylphenylamino)fluoran, 3-diethylamino-6-methyl-7-(2',6'-dimethylphenylamino)fluoran, 3-di-n-butylamino-6-methyl-7-(2',6'-dimethylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'(dimethylaminophenyl)]amino-5,7-dimethylfluoran,

phthalides such as 3-(2-methyl-4-diethylaminophenyl)-3-(1-ethyl-2-methylindol-3-yl)-4-azaphthalide, 3-(2-n-propoxycarbonylamino-4-di-n-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4-azaphthalide, 3-(2-ethoxy-4-diethylaminophenyl)-3-(1-octyl-2-methylindol-3-yl)-7-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-ethyl-2-methylindol-3-yl)-7-azaphthalide, 3-(2-hexyloxy-4-diethylaminophenyl)-3-(1-ethyl-2-methylindol-3-yl)-4-azaphthalide, 3-(2-hexyloxy-4-diethylaminophenyl)-3-(1-ethyl-2-methylindol-3-yl)-7-azaphthalide, 3-(2-ethoxy-4-diethylaminophenyl)-3-(1-ethyl-2-phenylindol-3-yl)-4-azaphthalide, 3-(2-ethoxy-4-diethylaminophenyl)-3-(1-ethyl-2-phenylindol-3-yl)-7-azaphthalide, 3-(2-butoxy-4-diethylaminophenyl)-3-(1-ethyl-2-phenylindol-3-yl)-4-azaphthalide, 3-(2-butoxy-4-diethylaminophenyl)-3-(1-ethyl-2-phenylindol-3-yl)-7-azaphthalide, 3-methyl-spiro-dinaphthopyran, 3-ethyl-spiro-dinaphthopyran, 3-phenyl-spiro-dinaphthopyran, 3-benzyl-spiro-dinaphthopyran, 3-methyl-naphtho-(3-methoxybenzo)spiropyran, 3-propyl-spiro-dibenzopyran-3,6-bis(dimethylamino)fluorene-9-spiro-3'-(6'-dimethylamino)p hthalide, and 3,6-bis(diethylamino)fluorene-9-spiro-3'-(6'-dimethylamino)phthalide.

Further, other examples thereof include 2'-anilino-6'-(N-ethyl-N-isopentyl)amino-3'-methylspiro[isobenzofuran-1(3H),9'-(9H)xanthe ne]-3-one, 2'-anilino-6'-(N-ethyl-N-(4-methylphenyl))amino-3'-methylspiro[isobenzofuran-1(3H),9'-(9H )xanthene]-3-one, 3'-N,N-dibenzylamino-6'-N,N-diethylaminospiro[isobenzofuran-1(3H),9'-(9H)xanthene]-3-o ne, and 2'-(N-methyl-N-phenyl)amino-6'-(N-ethyl-N-(4-methylphenyl))aminospiro[isobenzofuran-1( 3H),9'-(9H)xanthene]-3-one.

Among these, from the viewpoint of the color developability, it is preferable that the color forming agent used in the present disclosure is at least one compound selected from the group consisting of a spiropyran compound, a spirooxazine compound, a spirolactone compound, and a spirolactam compound.

From the viewpoint of the visibility, the hue of the coloring agent after color development is preferably green, blue, or black.

Further, from the viewpoints of the color developability and the visibility of the exposed portion, a leuco coloring agent is preferable as the acid color forming agent.

The leuco coloring agent is not particularly limited as long as the coloring agent has a leuco structure, but the leuco coloring agent has preferably a spiro structure and more preferably a spirolactone ring structure.

Further, from the viewpoints of the color developability and the visibility of the exposed portion, a leuco coloring agent having a phthalide structure or a fluoran structure is preferable as the leuco coloring agent.

Further, from the viewpoints of the color developability and the visibility of the exposed portion, the leuco coloring agent having a phthalide structure or a fluoran structure is preferably a compound represented by any of Formulae (Le-1) to (Le-3) and more preferably a compound represented by Formula (Le-2).

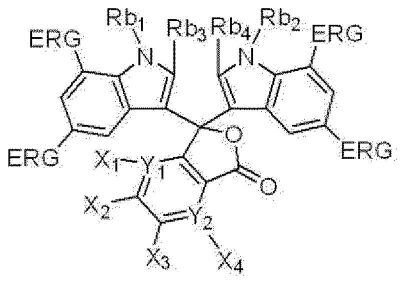

(Le-1)

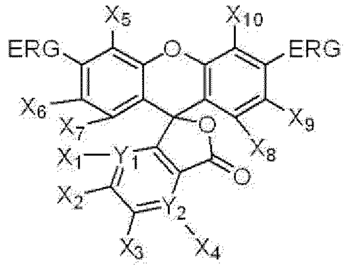

(Le-2)

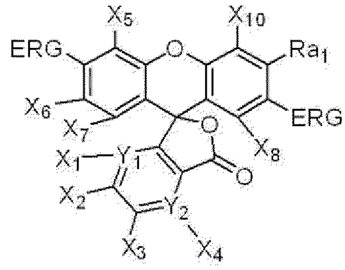

(Le-3)

In Formulae (Le-1) to (Le-3), ERG's each independently represent an electron-donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ is not present in a case where $Y_1$ represents N, and $X_4$ is not present in a case where $Y^2$ represents N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

From the viewpoints of the color developability and the visibility of the exposed portion, as the electron-donating group represented by ERG in Formulae (Le-1) to (Le-3), an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, an aryloxy group, a heteroaryloxy group, or an alkyl group is preferable, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, or an aryloxy group is more preferable, a monoalkylmonoarylamino group, a diarylamino group, a diheteroarylamino group, or a monoarylmonoheteroarylamino group is still more preferable, and a monoalkylmonoarylamino group is particularly preferable.

Further, from the viewpoints of the color developability and the visibility of the exposed portion, as the electron-donating group represented by ERG, a disubstituted amino group that contains an aryl group having a substituent at at least one ortho position or a heteroaryl group having a substituent at at least one ortho position is preferable, a disubstituted amino group that contains a phenyl group having a substituent at at least one ortho position and an electron-donating group at the para position is more preferable, an amino group that contains a phenyl group and an aryl group or a heteroaryl group having a substituent at at least one ortho position and an electron-donating group at the para position is still more preferable, and an amino group that contains a phenyl group having a substituent at at least one ortho position and an electron-donating group at the para position, an aryl group containing an electron-donating group, or a heteroaryl group containing an electron-donating group is particularly preferable.

In the present disclosure, the ortho position in an aryl group or a heteroaryl group other than a phenyl group denotes a bonding position (for example, a 2-position) next to a 1-position in a case where a bonding position of the aryl group or the heteroaryl group with respect to another structure is defined as the 1-position.

Further, from the viewpoints of the color developability and the visibility of the exposed portion, as the electron-donating group contained in the aryl group or the heteroaryl group, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, an aryloxy group, a heteroaryloxy group, or an alkyl group is preferable, an alkoxy group, an aryloxy group, a heteroaryloxy group, or an alkyl group is more preferable, and an alkoxy group is still more preferable.

From the viewpoints of the color developability and the visibility of the exposed portion, $X_1$ to $X_4$ in Formulae (Le-1) to (Le-3) each independently represent preferably a hydrogen atom or a chlorine atom and more preferably a hydrogen atom.

From the viewpoints of the color developability and the visibility of the exposed portion, $X_5$ to $X_{10}$ in Formula (Le-2) or Formula (Le-3) each independently represent preferably a hydrogen atom, a halogen atom, an alkyl group, an aryl group, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably a hydrogen atom, a halogen atom, an alkyl group, an aryl group, an alkoxy group, or an aryloxy group, still more preferably a hydrogen atom, a halogen atom, an alkyl group, or an aryl group, and particularly preferably a hydrogen atom.

From the viewpoints of the color developability and the visibility of the exposed portion, it is preferable that at least one of $Y_1$ or $Y_2$ in Formulae (Le-1) to (Le-3) represents C and more preferable that both $Y_1$ and $Y_2$ represent C.

From the viewpoints of the color developability and the visibility of the exposed portion, $Ra_1$ in Formulae (Le-1) to (Le-3) represents preferably an alkyl group or an alkoxy group, more preferably an alkoxy group, and still more preferably a methoxy group.

From the viewpoints of the color developability and the visibility of the exposed portion, $Rb_1$ to $Rb_4$ in Formulae (Le-1) to (Le-3) each independently represent preferably a hydrogen atom or an alkyl group, more preferably an alkyl group, and still more preferably a methyl group.

Further, from the viewpoints of the color developability and the visibility of the exposed portion, a compound represented by any of Formulae (Le-4) to (Le-6) is more preferable, and a compound represented by Formula (Le-5) is still more preferable as the leuco coloring agent having a phthalide structure or a fluoran structure.

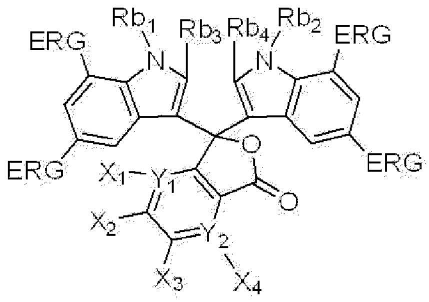

(Le-4)

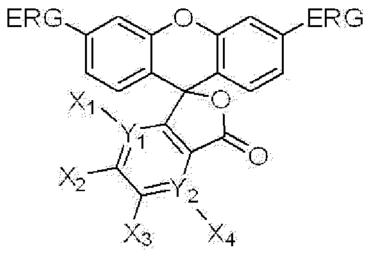

(Le-5)

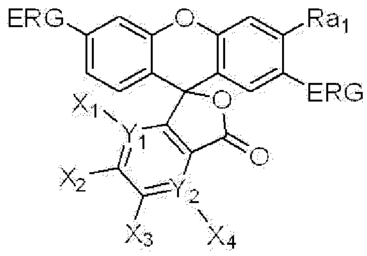

(Le-6)

In Formulae (Le-4) to (Le-6), ERG's each independently represent an electron-donating group, $X_1$ to $X_4$ each independently represent a hydrogen atom, a halogen atom, or a dialkylanilino group, $Y_1$ and $Y_2$ each independently represent C or N, $X_1$ is not present in a case where $Y_1$ represents N, and $X_4$ is not present in a case where $Y_2$ represents N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

ERG, $X_1$ to $X_4$, $Y_1$, $Y_2$, $Ra_1$, and $Rb_1$ to $Rb_4$ in Formulae (Le-4) to (Le-6) each have the same definition as that for ERG, $X_1$ to $X_4$, $Y_1$, $Y_2$, $Ra_1$, and $Rb_1$ to $Rb_4$ in Formulae (Le-1) to (Le-3), and the preferable aspects thereof are also the same as described above.

Further, from the viewpoints of the color developability and the visibility of the exposed portion, the leuco coloring agent having a phthalide structure or a fluoran structure is still more preferably a compound represented by any of Formulae (Le-7) to (Le-9) and particularly preferably a compound represented by Formula (Le-8).

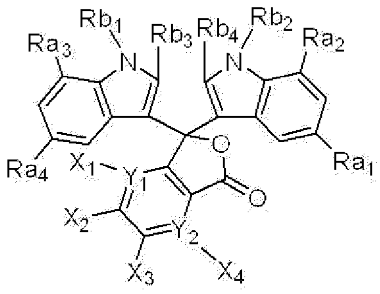

(Le-7)

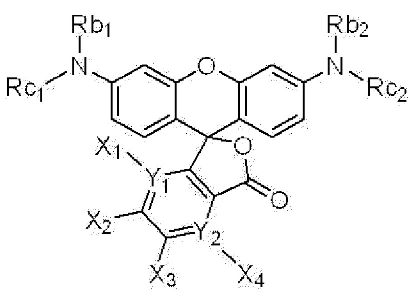

(Le-8)

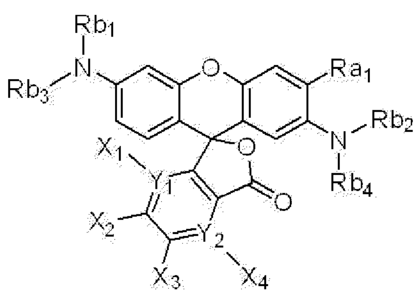

(Le-9)

In Formulae (Le-7) to (Le-9), $X_1$ to $X_4$ each independently represent a hydrogen atom, a halogen atom, or a dialkylanilino group, $Y_1$ and $Y_2$ each independently represent C or N, $X_1$ is not present in a case where $Y_1$ represents N, and $X_4$ is not present in a case where $Y_2$ represents N, $Ra_1$ to $Ra_4$ each independently represent a hydrogen atom, an alkyl group, or an alkoxy group, $Rb_1$ to $Rb_4$ each independently represent a hydrogen atom, an alkyl group, an aryl group, or a heteroaryl group, and $Rc_1$ and $Rc_2$ each independently represent an aryl group or a heteroaryl group.

$X_1$ to $X_4$, $Y_1$, and $Y_2$ in Formulae (Le-7) to (Le-9) each have the same definition as that for $X_1$ to $X_4$, $Y_1$, and $Y_2$ in Formulae (Le-1) to (Le-3), and the preferable aspects thereof are also the same as described above.

From the viewpoints of the color developability and the visibility of the exposed portion, $Ra_1$ to $Ra_4$ in Formulae

(Le-7) to (Le-9) each independently represent preferably an alkyl group or an alkoxy group, more preferably an alkoxy group, and still more preferably a methoxy group.

From the viewpoints of the color developability and the visibility of the exposed portion, $Rb_1$ to $Rb_4$ in Formulae (Le-7) to (Le-9) each independently represent preferably a hydrogen atom, an alkyl group, or an aryl group substituted with an alkoxy group, more preferably an alkyl group, and still more preferably a methyl group.

From the viewpoints of the color developability and the visibility of the exposed portion, $Rc_1$ and $Rc_2$ in Formula (Le-8) each independently represent preferably a phenyl group or an alkylphenyl group and more preferably a phenyl group.

Further, from the viewpoints of the color developability and the visibility of the exposed portion, $Rc_1$ and $Rc_2$ in Formula (Le-8) each independently represent preferably an aryl group having a substituent at at least one ortho position or a heteroaryl group having a substituent at at least one ortho position, more preferably an aryl group having a substituent at at least one ortho position, still more preferably a phenyl group having a substituent at at least one ortho position, and particularly preferably a phenyl group having a substituent at at least one ortho position and an electron-donating group at the para position. Examples of the substituents in $Rc_1$ and $Rc_2$ include substituents described below.

In Formula (Le-8), from the viewpoints of the color developability and the visibility of the exposed portion, it is preferable that $X_1$ to $X_4$ represent a hydrogen atom and that $Y_1$ and $Y_2$ represent C.

Further, in Formula (Le-8), from the viewpoints of the color developability and the visibility of the exposed portion, it is preferable that $Rb_1$ and $Rb_2$ each independently represent an alkyl group or an aryl group substituted with an alkoxy group.

Further, in Formula (Le-8), from the viewpoints of the color developability and the visibility of the exposed portion, $Rb_1$ and $Rb_2$ each independently represent preferably an aryl group or a heteroaryl group, more preferably an aryl group, still more preferably an aryl group having an electron-donating group, and particularly preferably a phenyl group containing an electron-donating group at the para position.

Further, from the viewpoints of the color developability and the visibility of the exposed portion, as the electron-donating group in $Rb_1$, $Rb_2$, $Rc_1$, and $Rc_2$, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, an aryloxy group, a heteroaryloxy group, or an alkyl group is preferable, an alkoxy group, an aryloxy group, a heteroaryloxy group, or an alkyl group is more preferable, and an alkoxy group is still more preferable.

Further, from the viewpoints of the color developability and the visibility of the exposed portion, it is preferable that the image recording layer contains a compound represented by Formula (Le-10) as the acid color forming agent.

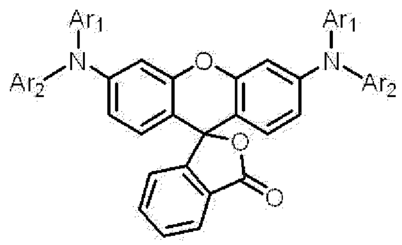

( Le - 10 )

In Formula (Le-10), An’s each independently represent an aryl group or a heteroaryl group, and $Ar_2$’s each independently represent an aryl group having a substituent at at least one ortho position or a heteroaryl group having a substituent at at least one ortho position.

An in Formula (Le-10) has the same definition as that for $Rb_1$ and $Rb_2$ in Formulae (Le-7) to (Le-9), and the preferable aspects thereof are the same as described above.

$Ar_2$ in Formula (Le-10) has the same definition as that for $Rc_1$ and $Rc_2$ in Formulae (Le-7) to (Le-9), and the preferable aspects thereof are the same as described above.

From the viewpoint of color developability and visibility of exposed portions, the acid color forming agent preferably includes a compound represented by Formula (Le-11).

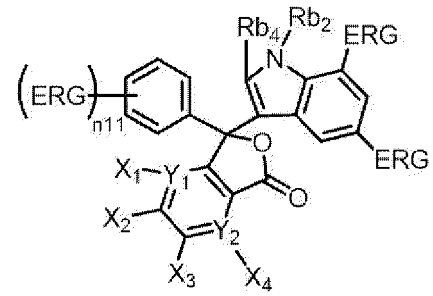

(Le - 11)

In Formula (Le-11), ERG's each independently represent an electron-donating group, n11 represents an integer of 1 to 5, $X_1$ to $X_4$ each independently represent a hydrogen atom, a halogen atom, or a dialkylanilino group, $Y_1$ and $Y_2$ each independently represent C or N, $X_1$ is not present in a case where $Y_1$ represents N, $X_4$ is not present in a case where $Y_2$ represents N, and $Rb_2$ and $Rb_4$ each independently represent a hydrogen atom, an alkyl group, an aryl group, or a heteroaryl group.

ERG, $X_1$ to $X_4$, $Y_1$, $Y_2$, $Rb_2$, and $Rb_4$ in Formula (Le-11) each have the same definition as that for ERG, $X_1$ to $X_4$, $Y_1$, $Y_2$, $Rb_2$, and $Rb_4$ in Formulae (Le-1) to (Le-3), and the preferable aspects thereof are also the same as described above.

n11 in Formula (Le-11) is preferably an integer of 1 to 3, and more preferably 1 or 2.

The alkyl group in Formulae (Le-1) to (Le-9) and (Le-11) may be linear or branched or may have a ring structure.

Further, the number of carbon atoms of the alkyl group in Formulae (Le-1) to (Le-9) and (Le-11) is preferably in a range of 1 to 20, more preferably in a range of 1 to 8, still more preferably in a range of 1 to 4, and particularly preferably 1 or 2.

The number of carbon atoms of the aryl group in Formulae (Le-1) to (Le-11) is preferably in a range of 6 to 20, more preferably in a range of 6 to 10, and still more preferably in a range of 6 to 8.

Specific examples of the aryl group in Formulae (Le-1) to (Le-11) include a phenyl group, a naphthyl group, an anthracenyl group, and a phenanthrenyl group, which may have a substituent.

Specific examples of the heteroaryl group in Formulae (Le-1) to (Le-11) include a furyl group, a pyridyl group, a pyrimidyl group, a pyrazoyl group, and a thiophenyl group, which may have a substituent.

Further, each of the monovalent organic group, the alkyl group, the aryl group, the heteroaryl group, the dialkylanilino group, the alkylamino group, and the alkoxy group in Formulae (Le-1) to (Le-10) may have a substituent. Examples of the substituent include an alkyl group, an aryl group, a heteroaryl group, a halogen atom, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, and a cyano group. Further, these substituents may be further substituted with these substituents.

Examples of the leuco coloring agent having a phthalide structure or a fluoran structure that is suitably used include the following compounds. In addition, Me represents a methyl group.

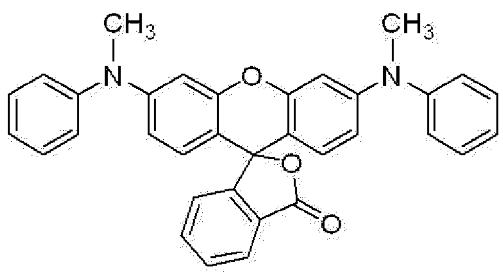

S - 1

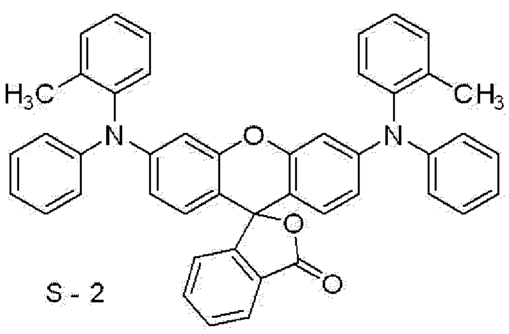

S - 2

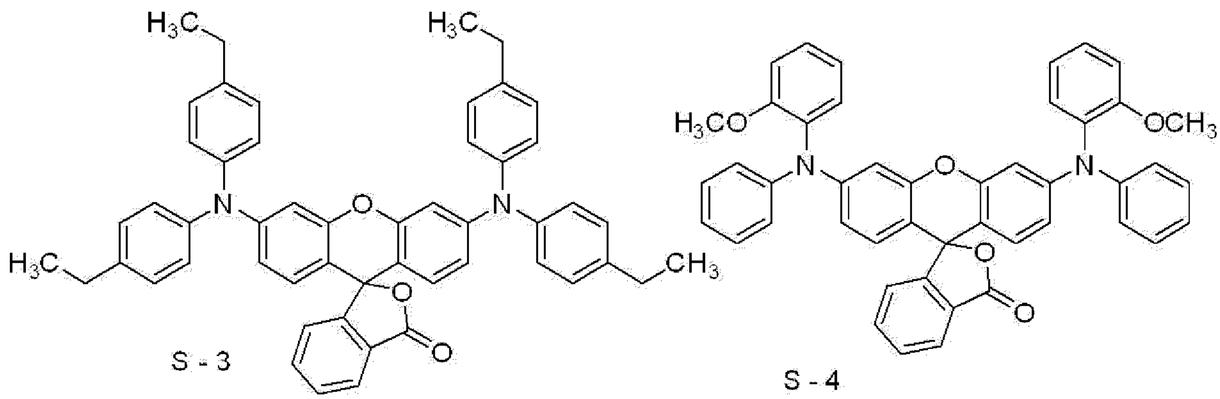

S - 3

S - 4

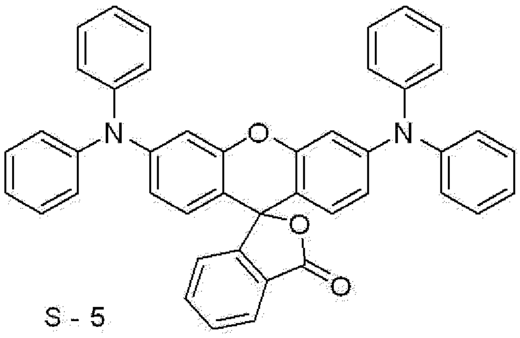

S - 5

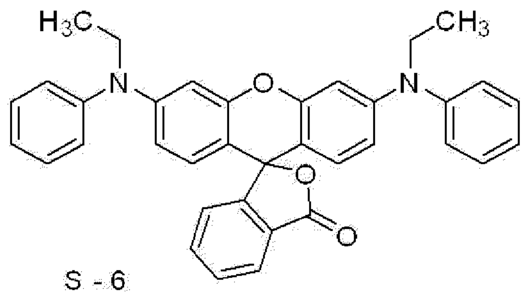

S - 6

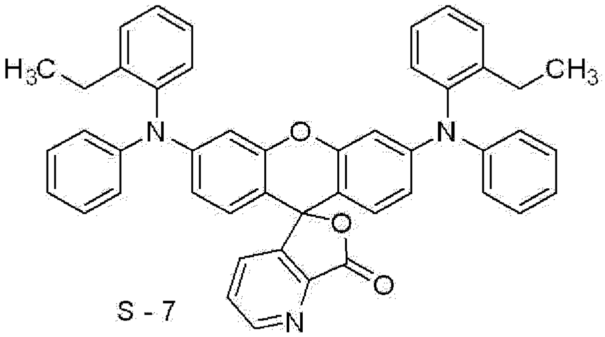

S - 7

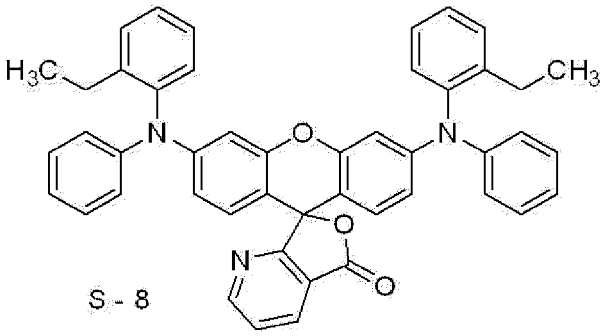

S - 8

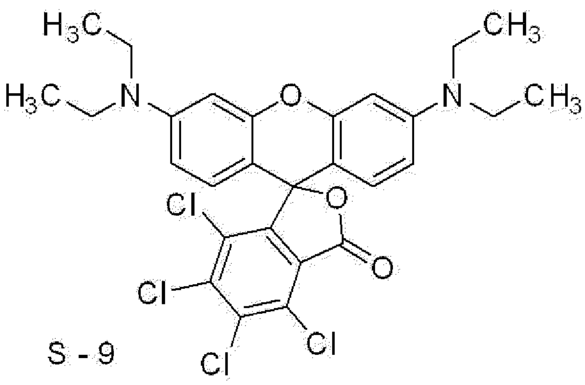

S - 9

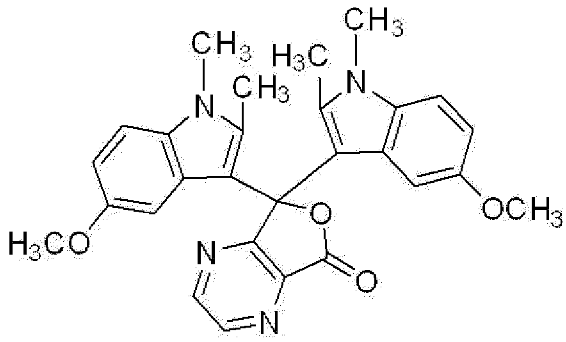

S - 10

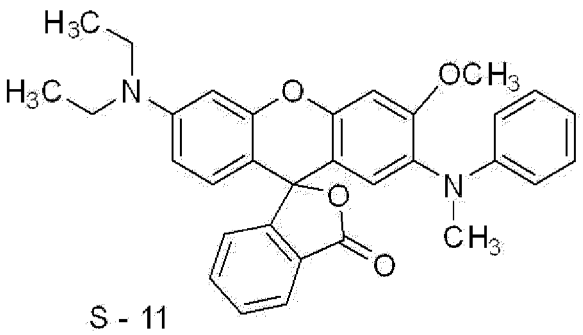

S - 11

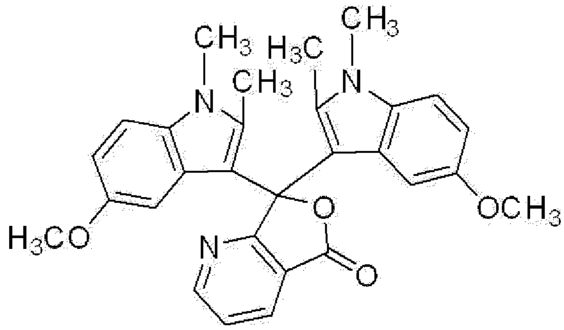

S - 12

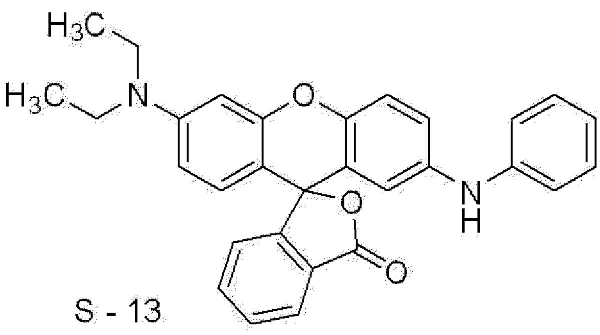

S - 13

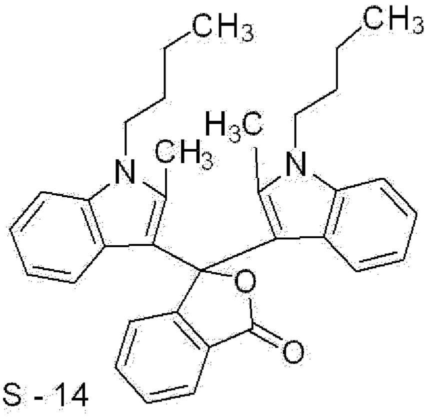

S - 14

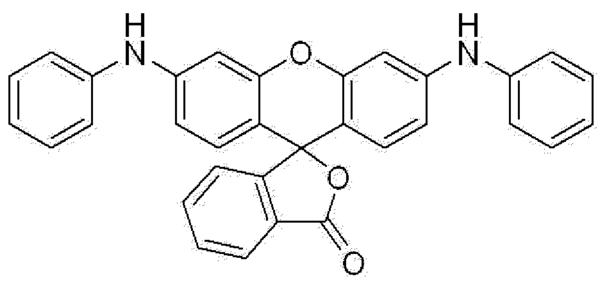

S - 15

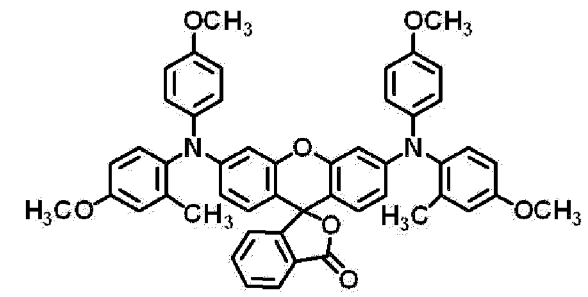

S - 16

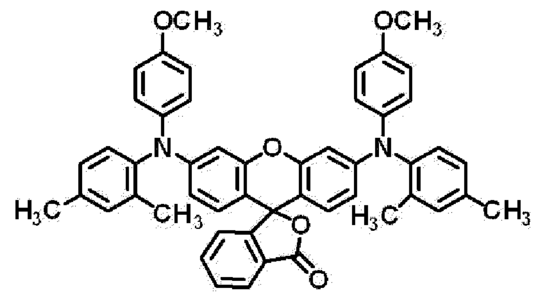

S - 17

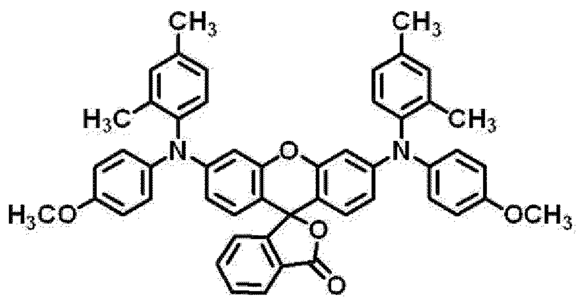

S - 18

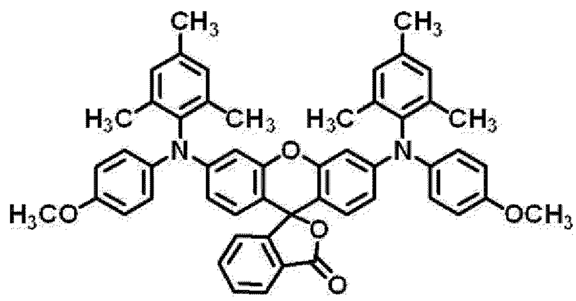

S - 19

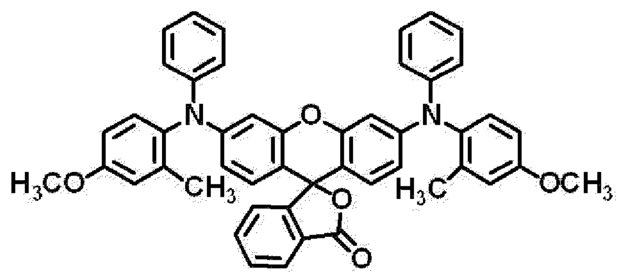

S - 20

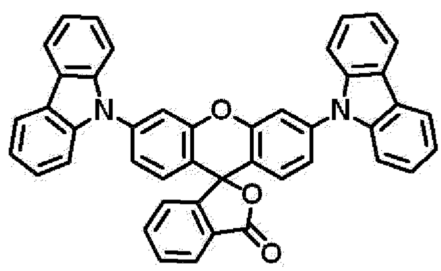

S - 21

As the acid color forming agent, a commercially available product can be used, and examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals Inc.), and Crystal Violet Lactone (manufactured by Tokyo Chemical Industry Co., Ltd.). Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and Crystal Violet Lactone are preferable from the viewpoint that the visible light absorbance of a film to be formed is satisfactory.

These color forming agents may be used alone or in combination of two or more kinds of components.

The content of the color forming agent is preferably in a range of 0.5% to 10% by mass and more preferably in a range of 1% to 5% by mass with respect to the total mass of the image recording layer.

The image recording layer 46 may further contain other compounds in addition to those described above as necessary.

Examples of other compounds include the coloring agent, the printing-out agent, the polymerization inhibitor, the higher fatty acid derivative, the plasticizer, the inorganic fine particles, and the low-molecular-weight hydrophilic compound disclosed in paragraphs [0181] to [0190] of JP2009-255434A.

As the polymerization inhibitor, for example, a known polymerization inhibitor such as phenothiazine can be used.

Examples of other compounds further include the hydrophobic precursor (fine particles capable of converting an image recording layer to be hydrophobic at the time addition of heat), the low-molecular-weight hydrophilic compound, the oil sensitizing agent (for example, a phosphonium compound, a nitrogen-containing low-molecular-weight compound, or an ammonium group-containing polymer), and the chain transfer agent disclosed in paragraphs [0191] to [0217] of JP2012-187907A.

[Other layers]

The lithographic printing plate precursor according to the embodiment of the present invention may include layers other than the support 42 for a lithographic printing plate, the undercoat layer 44, and the image recording layer 46 described above.
For example, for the purpose of preventing occurrence of scratches on the image recording layer 46, blocking oxygen, and preventing ablation in a case of exposure to a high illuminance laser, a protective layer may be provided on the image recording layer 46 as necessary.
Examples of the material used for the protective layer include the materials (such as a water-soluble polymer compound and an inorganic layered compound) described in paragraphs [0213] to [0227] of JP2009-255434A.

[Method of producing lithographic printing plate precursor]

It is preferable that the above-described method of producing the lithographic printing plate precursor according to the embodiment of the present invention is a production method of sequentially performing the following steps after the above-described method of producing the support for a lithographic printing plate according to the embodiment of the present invention.

(Undercoat layer forming step) A step of forming an undercoat layer on the support for a lithographic printing plate
(Image recording layer forming step) A step of forming an image recording layer on the undercoat layer

Hereinafter, the procedures of each step will be described in detail.

<Undercoat layer forming step>

An undercoat layer forming step is a step of forming an undercoat layer on the support for a lithographic printing plate.
The method of producing the undercoat layer is not particularly limited, and examples thereof include a method of coating the anodized film of the support for a lithographic printing plate with a coating solution for forming an undercoat layer which contains a predetermined compound (such as a compound having a betaine structure).
It is preferable that the coating solution for forming an undercoat layer contains a solvent. Examples of the solvent include water and an organic solvent.
Examples of the method of coating the film with the coating solution for forming an undercoat layer include various known methods. Examples of the known methods include bar coater coating, spin coating, spray coating, curtain coating, dip coating, air knife coating, blade coating, and roll coating.
The coating amount (solid content) of the undercoat layer is preferably in a range of 0.1 to 100 $mg/m^2$.

<Image recording layer forming step>

The image recording layer forming step is a step of forming an image recording layer on the undercoat layer.
The method of forming the image recording layer is not particularly limited, and examples thereof include a method of coating the undercoat layer with a coating solution for forming an image recording layer that contains a predetermined component (such as the infrared absorber, the polymerization initiator, or the polymerizable compound described above).
It is preferable that the coating solution for forming an image recording layer contains a solvent. Examples of the solvent include water and an organic solvent.
Examples of the method of applying the coating solution for forming an image recording layer include the methods exemplified as the method of applying the coating solution for forming an undercoat layer.
The coating amount (solid content) of the image recording layer varies depending on the purpose thereof, but is typically preferably in a range of 0.3 to 3.0 $g/m^2$.
In a case where a protective layer is provided on the image recording layer, the method of producing the protective layer is not particularly limited, and examples thereof include a method of coating the image recording layer

with a coating solution for forming a protective layer which contains a predetermined component.

Further, the aspect of the lithographic printing plate precursor using the undercoat layer 44 has been described in Fig. 8. However, as described above, the lithographic printing plate precursor may not include the undercoat layer.

In a case where the undercoat layer is not provided, an image recording layer may be formed after a hydrophilization treatment is performed on the support for a lithographic printing plate.

Examples of the hydrophilization treatment include known methods described in paragraphs [0109] to [0114] of JP2005-254638A. Among the examples, it is preferable that the hydrophilization treatment is performed using a method of immersing the support in an aqueous solution of alkali metal silicate such as sodium silicate or potassium silicate or a method of coating the support with a hydrophilic vinyl polymer or a hydrophilic compound to form a hydrophilic undercoat layer.

The hydrophilization treatment using an aqueous solution of alkali metal silicate such as sodium silicate or potassium silicate can be performed according to the procedures and the methods described in US2714066A and US3181461A.

[Method of producing lithographic printing plate]

Next, a method of producing a lithographic printing plate using the lithographic printing plate precursor will be described.

The method of producing a lithographic printing plate typically includes an exposing step of imagewise-exposing (image-exposing) the lithographic printing plate precursor to form an exposed portion and an unexposed portion and a step of removing the unexposed portion of the imagewise-exposed lithographic printing plate precursor.

More specifically, according to an aspect of the method of producing a lithographic printing plate, a method of producing a lithographic printing plate which includes an exposing step of imagewise-exposing (image-exposing) the lithographic printing plate precursor to form an exposed portion and an unexposed portion and a removing step of removing the unexposed portion of the lithographic printing plate precursor using a developer with a pH of 2 to 12 is exemplified.

Further, according to another aspect of the method of producing a lithographic printing plate, a method of producing a lithographic printing plate which includes an exposing step of imagewise-exposing (image-exposing) the lithographic printing plate precursor to form an exposed portion and an unexposed portion and an on-press developing step of supplying at least one of a printing ink or dampening water and removing the unexposed portion of the imagewise-exposed lithographic printing plate precursor on a printing press is exemplified.

Hereinafter, these embodiments will be described.

The method of producing a lithographic printing plate includes a step of imagewise-exposing (image-exposing) the lithographic printing plate precursor (particularly, a step of image-exposing the lithographic printing plate precursor to an infrared laser). The image exposure is performed by laser exposure through a transparent original picture having a line image, a halftone image, and the like or by laser beam scanning using digital data.

The wavelength of a light source is preferably in a range of 750 to 1,400 nm. In case of the light source that emits light having a wavelength of 750 to 1,400 nm, an image recording layer containing an infrared absorber which is a sensitizing dye having absorption in this wavelength range is preferably used.

As the light source having a wavelength of 750 to 1,400 nm, a solid-state laser or a semiconductor laser that radiates infrared rays is exemplified. The output of the infrared laser is preferably 100 mW or greater, the exposure time per one pixel is preferably equal to or shorter than 20 microseconds, and the irradiation energy quantity is preferably in a range of 10 to 300 $mJ/cm^2$. For the purpose of reducing the exposure time, it is preferable to use a multi-beam laser device. The exposure mechanism may be any of an internal drum system, an external drum system, and a flat bed system.

The image exposure can be performed by a known method using a plate setter. In a case of the on-press development method described below, the lithographic printing plate precursor may be image-exposed on the printing press after the lithographic printing plate precursor is mounted on the printing press.

The image-exposed lithographic printing plate precursor is subjected to a development treatment according to a method (developer treatment method) of removing the unexposed portion using a developer with a pH of 2 to 12 or a method (on-press development method) of removing the unexposed portion using at least one of a printing ink or dampening water on the printing press.

<Developer treatment method>

In the developer treatment method, the image-exposed lithographic printing plate precursor is treated by a developer with a pH of 2 to 14, and the image recording layer of the unexposed portion is removed to produce a lithographic printing plate.

As the developer, a developer with a pH of 5 to 10 which contains at least one acid group selected from the

group consisting of a phosphoric acid group, a phosphonic acid group, and a phosphinic acid group and a compound (specific compound) containing one or more carboxyl groups is preferable.

In a case where the development treatment is carried out manually, a method of allowing sponge or absorbent cotton to sufficiently contain a developer, performing the treatment while rubbing the entire lithographic printing plate precursor, and sufficiently drying the developer after completion of the treatment is exemplified. In a case of an immersion treatment, a method of immersing the lithographic printing plate precursor in a tray, a deep tank, or the like containing a developer therein for approximately 60 seconds, stirring the solution, and sufficiently drying the solution while rubbing the lithographic printing plate precursor with absorbent cotton or sponge is exemplified.

It is preferable that a device capable of simplifying the structure and the steps is used in the development treatment.

In a development treatment of the related art, a protective layer is removed by the pre-water washing step, development is performed using an alkaline developer, an alkali is removed by the post-water washing step, the gum treatment is performed by a gum coating step, and drying is performed by a drying step.

In addition, development and gum coating can be simultaneously performed using one liquid. As the gum, a polymer is preferable, and a water-soluble polymer compound or a surfactant is more preferable.

Further, it is preferable that removal of the protective layer, development, and gum coating are simultaneously performed using one liquid without performing the pre-water washing step. Further, it is preferable that the excessive developer is removed using a squeeze roller after the development and the gum coating and then drying is performed.

The present treatment may be performed according to a method of performing immersion in a developer once or a method of performing immersion twice or more times. Among these, a method of performing immersion in the developer once or twice is preferable.

The immersion may be carried out by passing the exposed lithographic printing plate precursor through a developing tank in which the developer is stored or spraying the developer onto the plate surface of the exposed lithographic printing plate precursor using a spray or the like.

Further, the development treatment is performed using one liquid (one liquid treatment) even in a case where the lithographic printing plate precursor is immersed in the developer twice or more times or in a case where the lithographic printing plate precursor is immersed, twice or more times, in the same developer as described above or a developer (fatigue liquid) obtained by dissolving or dispersing components of the image recording layer using the developer and the development treatment.

In the development treatment, it is preferable to use a rubbing member and also preferable that a rubbing member such as a brush is installed in a developing bath which removes a non-image area of the image recording layer.

The development treatment can be performed by immersing the lithographic printing plate precursor which has been subjected to the exposure treatment and rubbing the plate surface with brushes or pumping up the treatment liquid added to an external tank using a pump, spraying the developer from a spray nozzle, and rubbing the plate surface with brushes, at a temperature of preferably in a range of 0°C to 60°C and more preferably in a range of 15°C to 40°C using a known method. These development treatments can be continuously performed plural times. For example, the development treatment can be performed by pumping up the developer added to an external tank using a pump, spraying the developer from a spray nozzle, rubbing the plate surface with brushes, spraying the developer from the spray nozzle again, and rubbing the plate surface with the brushes. In a case where the development treatment is performed using an automatic development device, since the developer becomes fatigued as the treatment amount increases, it is preferable that the treatment capability is recovered using a replenisher or a fresh developer.

The development treatment of the present disclosure can also be performed using a gum coater or an automatic development device which has been known to be used for a presensitized (PS) plate and CTP (computer to plate) in the related art. In a case where an automatic development device is used, for example, any method from among a method of performing the treatment by pumping up the developer added to a developing tank or the developer added to an external tank using a pump and spraying the developer from a spray nozzle, a method of performing the treatment by immersing a printing plate in a tank filled with the developer and transporting the printing plate using a guide roller in the developer, and a so-called disposable treatment method, which is a method of performing the treatment by supplying the substantially unused developer by an amount required for each plate can be employed. In all methods, it is more preferable that a rubbing mechanism using brushes or a molleton is provided. For example, commercially available automatic development devices (Clean Out Unit C85/C125, Clean-Out Unit + C85/120, FCF 85V, FCF 125V, FCF News (manufactured by Glunz & Jensen)); and Azura CX85, Azura CX125, and Azura CX150 (manufactured by AGFA GRAPHICS) can be used. In addition, a device in which a laser exposure portion and an automatic development device portion are integrally incorporated can also be used.

<On-press development method>

In the on-press development method, printing ink and dampening water are supplied on the printing press, and

the image recording layer of the non-image area is removed to produce a lithographic printing plate using the image-exposed lithographic printing plate precursor.

In other words, the lithographic printing plate precursor is image-exposed, and the lithographic printing plate precursor is directly mounted on the printing press without performing any developer treatment or the lithographic printing plate precursor is mounted on the printing press, image-exposed on the printing press, and printed by supplying printing ink and dampening water. At the initial stage of the printing, the image recording layer of the unexposed portion is dissolved or dispersed and removed by the supplied printing ink and/or dampening water in the non-image area, and thus the hydrophilic surface in the removed portion is exposed. Meanwhile, the image recording layer cured by exposure forms an oil-based ink receiving unit having a lipophilic surface in the exposed portion. Printing ink or dampening water may be initially supplied to the plate surface, but it is preferable that printing ink is supplied thereto from the viewpoint of preventing contamination due to the components of the image recording layer from which dampening water has been removed.

In this manner, the lithographic printing plate precursor is on-press developed on the printing press and used as it is for printing a plurality of sheets. That is, according to an aspect of the printing method according to the embodiment of the present invention, a printing method including an exposing step of imagewise-exposing the lithographic printing plate precursor to form an exposed portion and an unexposed portion, and a printing step of supplying at least one of printing ink or dampening water and removing the unexposed portion of the imagewise-exposed lithographic printing plate precursor on a printing press and performing printing is exemplified.

In the method of producing a lithographic printing plate from the lithographic printing plate precursor according to the embodiment of the present invention, regardless of the development method, the entire surface of the lithographic printing plate precursor may be heated before the image exposure, during the image exposure, or during the time period from the image exposure to the development treatment as necessary.

Examples

Hereinafter, the features of the present invention will be described in more detail with reference to examples and comparative examples. The materials, the used amounts, the proportions, the treatment contents, the treatment procedures, and the like shown in the examples below can be appropriately changed within a range not departing from the gist of the present invention. Accordingly, the scope of the present invention should not be construed as being limited by the specific examples given below.

[Production of support for lithographic printing plate]

An aluminum plate (aluminum alloy plate) formed of a material 1S having a thickness of 0.3 mm was subjected to the following treatments to produce a support for a lithographic printing plate. Moreover, during all treatment steps, a water washing treatment was performed, and liquid cutting was performed using a nip roller after the water washing treatment.

[Example 1]

<First alkali etching treatment>

The aluminum plate was subjected to an etching treatment by spraying a caustic soda aqueous solution in which the concentration of caustic soda was 26% by mass and the concentration of aluminum ions was 6.5% by mass using a spray at a temperature of 70°C. Thereafter, the aluminum plate was washed with water using a spray. The amount of aluminum dissolved in the surface to be subsequently subjected to an electrochemical roughening treatment was 5 g/$m^2$.

<First desmutting treatment using acidic aqueous solution>

Next, a desmutting treatment was performed using an acidic aqueous solution. Specifically, the desmutting treatment was performed by spraying the acidic aqueous solution to the aluminum plate for 3 seconds using a spray. As the acidic aqueous solution used for the desmutting treatment, an aqueous solution containing 150 g/L of sulfuric acid was used. The liquid temperature was 30°C.

<Electrochemical roughening treatment>

Next, an electrochemical roughening treatment was performed using the alternating current and an electrolytic

solution having a hydrochloric acid concentration of 10 g/L, an aluminum ion concentration of 15 g/L, and a sulfuric acid concentration of 1.0 g/L. The liquid temperature of the electrolytic solution was 15°C. The aluminum ion concentration was adjusted by adding aluminum chloride.

The waveform of the alternating current was a sine wave in which the positive and negative waveforms were symmetrical, the frequency was 50 Hz, the ratio between the anodic reaction time and the cathodic reaction time in one cycle of the alternating current was 1:1, and the current density was 35 A/$dm^2$ in terms of the peak current value of the alternating current waveform. Further, the total electric quantity of the aluminum plate used for the anodic reaction was 350 C/$dm^2$, and the electrolytic treatment was performed ten times with intervals of a rest time of 1 minute. A carbon electrode was used as a counter electrode of the aluminum plate. Thereafter, a water washing treatment was performed.

<Second alkali etching treatment>

The aluminum plate after being subjected to the electrochemical roughening treatment was subjected to an etching treatment by spraying a caustic soda aqueous solution in which the concentration of caustic soda was 5% by mass and the concentration of aluminum ions was 0.5% by mass using a spray at a temperature of 45°C. The amount of aluminum dissolved in the surface after being subjected to an electrochemical roughening treatment was 0.1 g/$m^2$. Thereafter, a water washing treatment was performed.

<Desmutting treatment using acidic aqueous solution>

Next, a desmutting treatment was performed using an acidic aqueous solution. Specifically, the desmutting treatment was performed by spraying the acidic aqueous solution to the aluminum plate for 3 seconds using a spray. As the acidic aqueous solution used for the desmutting treatment, an aqueous solution having a sulfuric acid concentration of 170 g/L and an aluminum ion concentration of 5 g/L was used. The liquid temperature was 35°C.

<First-stage anodization treatment>

A first-stage anodization treatment was performed using an electrolytic solution containing sulfuric acid by applying an anodization device for DC electrolysis with the structure illustrated in Fig. 9. The sulfuric acid concentration in the electrolytic solution was 1 g/L, the liquid temperature of the electrolytic solution was 40°C, the current density was 20 A/$dm^2$, and the film thickness was 100 μm.

In an anodization treatment device 610 shown in Fig. 9, an aluminum plate 616 is transported as indicated by the arrow in Fig. 6. The aluminum plate 616 is positively (+) charged by a power supply electrode 620 in a power supply tank 612 in which an electrolytic solution 618 is stored. Further, the aluminum plate 616 is transported upward by a roller 622 in the power supply tank 612, redirected downward by a nip roller 624, transported toward an electrolytic treatment tank 614 in which an electrolytic solution 626 is stored, and redirected to the horizontal direction by a roller 628. Next, the aluminum plate 616 is negatively (-) charged by an electrolytic electrode 630 so that an anodized film is formed on the surface thereof, and the aluminum plate 616 coming out of the electrolytic treatment tank 614 is transported to the next step. In the anodization treatment device 610, a direction changing unit is formed of the roller 622, the nip roller 624, and the roller 628. The aluminum plate 616 is transported in a mountain shape and an inverted U shape by the roller 622, the nip roller 624, and the roller 628 in an inter-tank portion between the power supply tank 612 and the electrolytic treatment tank 614. The power supply electrode 620 and the electrolytic electrode 630 are connected to a DC power source 634. A tank wall 632 is disposed between the power supply tank 612 and the electrolytic treatment tank 614.

<Pore-widening treatment (PW treatment)>

The aluminum plate subjected to the anodization treatment was subjected to a pore-widening treatment by being immersed in a caustic soda aqueous solution in which the concentration of caustic soda was 5% by mass and the concentration of aluminum ions was 0.5% by mass at a temperature of 35°C for 4 seconds. Thereafter, the aluminum plate was washed with water using a spray.

<Second-stage anodization treatment (second AD)>

A second-stage anodization treatment was performed using an electrolytic solution containing sulfuric acid by applying an anodization device for DC electrolysis with the structure illustrated in Fig. 9. The sulfuric acid concentration in the electrolytic solution was 1 g/L, the liquid temperature of the electrolytic solution was 25°C, and the current density was 40 A/$dm^2$.

<Examples 2 to 22 and Comparative Examples 1 to 6>

A support for a lithographic printing plate was prepared by the same procedures as in Example 1 except that the production conditions in Example 1 were changed as listed in Table 1.

In Examples 19 and 20, a second-stage anodization treatment (second AD) was performed using an electrolytic solution containing phosphoric acid by applying an anodization device for DC electrolysis with the structure illustrated in Fig. 9 as described in the section <second-stage anodization treatment>, and a third-stage anodization treatment (third AD) was performed using an electrolytic solution containing sulfuric acid by applying an anodization device for DC electrolysis with the structure illustrated in Fig. 9.

In the second AD of Examples 19 and 20, the concentration of phosphoric acid in the electrolytic solution was 100 g/L, the liquid temperature of the electrolytic solution was 30°C, the current density was 8 $A/dm^2$, and the treatment time was as listed in Table 1.

Further, in the third AD of Examples 19 and 20, the concentration of sulfuric acid in the electrolytic solution was 1 g/L, the liquid temperature of the electrolytic solution was 40°C, the current density was 35 $A/dm^2$, and the treatment time was as listed in Table 1.

In Table 1, the columns of "first alkali etching ($g/m^2$)" denote the amount ($g/m^2$) of dissolved aluminum in the first alkali etching.

In Table 1, the columns of "liquid temperature (°C)" in the column of "electrochemical roughening treatment" denote the liquid temperature (°C) of the electrolytic solution in the electrochemical roughening treatment.

In Table 1, the columns of "number of times of electrolysis" in the column of "electrochemical roughening treatment" denote the number of times the electrolytic treatment was performed with intervals of a rest time of 1 second in the electrochemical roughening treatment.

In Table 1, the columns of "second alkali etching ($g/m^2$)" denote the amount of dissolved aluminum ($g/m^2$) in the second alkali etching.

In Table 1, the columns of "immersion time (sec)" in the column of "PW treatment" denote the seconds during which the aluminum plate subjected to the anodization treatment in the PW treatment was immersed in the caustic soda aqueous solution.

In Table 1, the columns of "treatment time (sec)" in the column of "second AD" denote the treatment time (sec) of the second AD treatment.

In Table 1, the columns of "treatment time (sec)" in the column of "third AD" denote the treatment time (sec) of the third AD treatment.

[Table 1]

| | First alkali etching ($g/m^2$) | Electrochemical roughening treatment | | Second alkali etching ($g/m^2$) | PW treatment | Second AD | Third AD |
|---|---|---|---|---|---|---|---|
| | | Liquid temperature (°C) | Number of times of electrolysis (number of times) | | Immersion time (sec) | Treatment time (sec) | Treatment time (sec) |
| Example 1 | 5 | 15 | 10 | 0.1 | 4 | 6 | - |
| Example 2 | 5 | 12 | 10 | 0.1 | 4 | 6 | - |
| Example 3 | 5 | 8 | 12 | 0.1 | 4 | 6 | - |
| Example 4 | 5 | 15 | 10 | 0.1 | 4 | 6 | - |
| Example 5 | 5 | 8 | 14 | 0.1 | 4 | 6 | - |
| Example 6 | 5 | 5 | 16 | 0.1 | 4 | 6 | - |
| Example 7 | 5 | 10 | 11 | 0.1 | 4 | 6 | - |
| Example 8 | 5 | 10 | 13 | 0.1 | 4 | 6 | - |
| Example 9 | 5 | 10 | 12 | 0.3 | 4 | 6 | - |
| Example 10 | 5 | 10 | 12 | 0.05 | 4 | 6 | - |
| Example 11 | 5 | 10 | 12 | 0.1 | 4 | 8 | - |
| Example 12 | 5 | 10 | 12 | 0.1 | 4 | 9 | - |

(continued)

| | First alkali etching ($g/m^2$) | Electrochemical roughening treatment | | Second alkali etching ($g/m^2$) | PW treatment | Second AD | Third AD |
|---|---|---|---|---|---|---|---|
| | | Liquid temperature (°C) | Number of times of electrolysis (number of times) | | Immersion time (sec) | Treatment time (sec) | Treatment time (sec) |
| Example 13 | 5 | 10 | 12 | 0.1 | 4 | 10 | - |
| Example 14 | 5 | 10 | 12 | 0.1 | 4 | 12 | - |
| Example 15 | 5 | 10 | 12 | 0.1 | 4 | 14 | - |
| Example 16 | 5 | 10 | 12 | 0.1 | 1 | 6 | - |
| Example 17 | 5 | 10 | 12 | 0.1 | 6 | 6 | - |
| Example 18 | 5 | 10 | 12 | 0.1 | 8 | 6 | - |
| Example 19 | 5 | 10 | 12 | 0.1 | 2 | 3 | 6 |
| Example 20 | 5 | 10 | 12 | 0.1 | 4 | 5 | 6 |
| Example 21 | 5 | 8 | 14 | 0.1 | 4 | 6 | - |
| Example 22 | 5 | 8 | 14 | 0.1 | 4 | 6 | - |
| Comparative Example 1 | 5 | 25 | 8 | 0.1 | 4 | 0 | 6 |
| Comparative Example 2 | 5 | 25 | 4 | 0.1 | 4 | 0 | 6 |
| Comparative Example 3 | 5 | 25 | 2 | 0.1 | 4 | 9 | 6 |
| Comparative Example 4 | 5 | 25 | 4 | 0.1 | 4 | 0 | 6 |
| Comparative Example 5 | 5 | 25 | 4 | 0.1 | 1 | 0 | 6 |
| Comparative Example 6 | 5 | 40 | 1 | 0.1 | 4 | 0 | 4 |

The average value of the equivalent circular diameters of projections in a cut surface, the density of the projections, and the value of the surface area ratio ΔS in the prepared support for a lithographic printing plate were measured by the above-described methods. These results are listed in Table 3.

In addition, the average diameter of large-diameter pore portions in the surface of the anodized film having micropores, the average diameter of small-diameter pore portions at communication positions, and the depths of the large-diameter pore portions and the small-diameter pore portions in the prepared aluminum support were measured by the above-described methods. These results are listed in Table 3.

In Examples 19 and 20, "average diameter" and "depth" in the column of "large-diameter pore portions" each denote the average diameter and the depth of "upper pore portions" in the surface of the anodized film, and the columns of "inner diameter" denote the maximum diameter of the upper pore portions. Further, in Examples 19 and 20, "average diameter" and "depth" in the columns of "small-diameter pore portions" each denote the average diameter and the depth of "lower pore portions" at the communication positions with the upper pore portions.

An undercoat layer was formed on the surface of the anodized film of each support for a lithographic printing plate prepared above using any of the following coating solutions 1 and 2 for an undercoat layer, and an image recording layer was formed on the formed undercoat layer using any of the following coating solutions 1 to 3 for an image recording layer, thereby producing a lithographic printing plate precursor.

The combination of the coating solution for an undercoat layer and the coating solution for an image recording layer used are as listed in Table 2. As listed in Table 2, a protective layer was further formed on the image recording layer using a coating solution for a protective layer in a case of formulations B and C.

The formulations used in each example and each comparative example are listed in Table 3.

The columns "coating solution for undercoat layer" of Table 2 denote the kind of the coating solution for an undercoat layer used, and "1" denotes a coating solution 1 for an undercoat layer.

The columns "coating solution for image recording layer" of Table 2 denote the kind of the coating solution for an image recording layer used, "1" denotes a coating solution 1 for an image recording layer, "2" denotes a coating solution 2 for an image recording layer, and "3" denotes a coating solution 3 for an image recording layer.

The columns "coating solution for protective layer" of Table 2 denote the kind of the coating solution for a protective layer used, "1" denotes a coating solution 1 for a protective layer, "2" denotes a coating solution 2 for a protective layer, and "-" denotes that the coating solution for a protective layer was not used.

The procedure for forming each layer will be described in detail below.

[Table 2]

| | Coating solution for undercoat layer | Coating solution for image recording layer | Coating solution for protective layer |
|---|---|---|---|
| Formulation A | 1 | 1 | - |
| Formulation B | 1 | 2 | 1 |
| Formulation C | 1 | 3 | 2 |

[Formation of undercoat layer]

The surface of the anodized film of each support for a lithographic printing plate prepared above was coated with the coating solution 1 for an undercoat layer such that the dry coating amount was set to 0.1 g/m$^2$, thereby forming an undercoat layer.

(Coating solution 1 for undercoat layer)

The following components were mixed to prepare a coating solution 1 for an undercoat layer.

- · Compound for undercoat layer (P-1 shown below, 11 mass% aqueous solution): 0.10502 parts by mass
- · Sodium gluconate: 0.07000 parts by mass
- · Surfactant (EMALEX 710, manufactured by Nihon Emulsion Co., Ltd.): 0.00159 parts by mass
- · Preservative (BIOHOPE L, manufactured by K·I Chemical Industry Co., Ltd.): 0.00149 parts by mass
- · Water: 2.87190 parts by mass

P-1 (hereinafter, see structural formula)

(P-1)

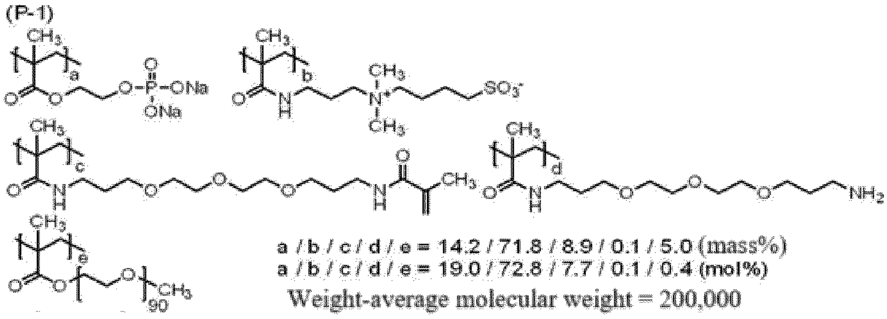

a / b / c / d / e = 14.2 / 71.8 / 8.9 / 0.1 / 5.0 (mass%)
a / b / c / d / e = 19.0 / 72.8 / 7.7 / 0.1 / 0.4 (mol%)
Weight-average molecular weight = 200,000

[Formation of image recording layer]

In regard to the coating solution 1 for an image recording layer, the undercoat layer of the support for a lithographic printing plate on which the undercoat layer had been formed was bar-coated with the coating solution 1 for an image recording layer and dried in an oven at 50°C for 60 seconds to form an image recording layer having a dry coating

amount of 0.9 g/$m^2$, thereby obtaining a lithographic printing plate precursor.

Further, in regard to the coating solutions 2 and 3 for an image recording layer, the undercoat layer of the support for a lithographic printing plate on which the undercoat layer had been formed was bar-coated with any of the coating solutions 2 and 3 for an image recording layer and dried in an oven at 120°C for 40 seconds to form an image recording layer having a dry coating amount of 1.0 g/$m^2$, thereby obtaining a lithographic printing plate precursor.

(Coating solution 1 for image recording layer)

The following components were mixed to prepare a coating solution 1 for an image recording layer.

· Polymer dispersion liquid: 0.675 parts by mass
· Hydroxypropyl methyl cellulose: 0.400 parts by mass
· Monomer 1: 0.036 parts by mass
· Monomer 2: 0.115 parts by mass
· Monomer 3: 0.087 parts by mass
· Infrared ray (IR) coloring agent: 0.028 parts by mass
· Surfactant: 0.045 parts by mass
· Iodonium salt 1: 0.073 parts by mass
· Iodonium salt 2: 0.053 parts by mass
· Leuco coloring agent: 0.040 parts by mass
· Phenothiazine: 0.005 parts by mass
· 1-Propanol: 2.6 parts by mass
· 2-Butanone: 3.5 parts by mass
· 1-Methoxy-2-propanol: 0.92 parts by mass
· δ-butyrolactone: 0.10 parts by mass
· Water: 1.16 parts by mass

Polymer dispersion liquid: a polymer dispersion liquid was prepared according to Example 10 of EP1,765,593. Further, the solvent was formed of n-propanol/water at a mass ratio of 80:20, and was used as a dispersion liquid having a concentration of solid contents of 23.5% by mass.

Hydroxypropyl methyl cellulose: used as an aqueous solution having a concentration of solid contents of 5%. 30% of the OH group in the hydroxypropyl methyl cellulose is methoxylated, and 10% thereof is hydroxypropoxylated. Further, the viscosity of the aqueous solution having a concentration of solid contents of 2% by mass at 20°C was 5 mPa-sec.

Monomer 1

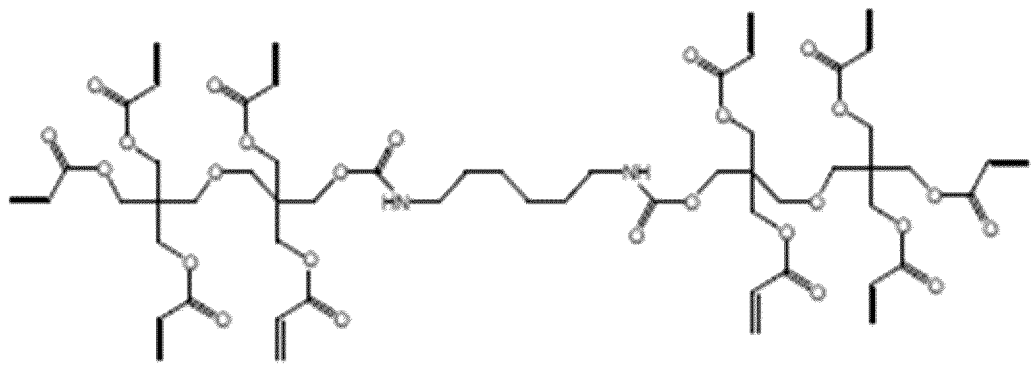

Monomer 2

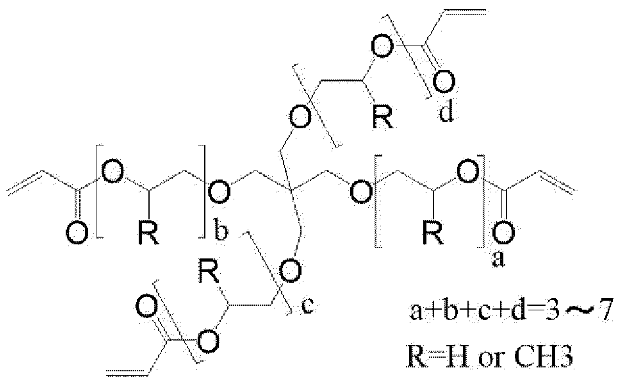


Monomer 3

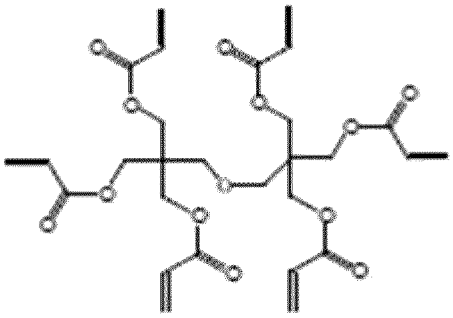

IR coloring agent

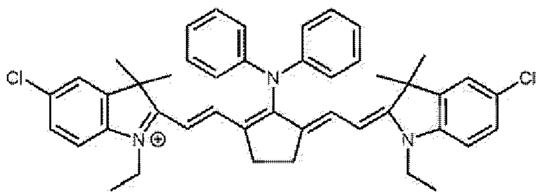

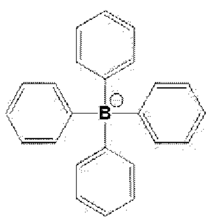

Surfactant: BYK (registered trademark) 302, manufactured by BYK-Chemie GmbH was used as a 25 mass% solution of 1-methoxy-2-propanol.

Iodonium salt 1

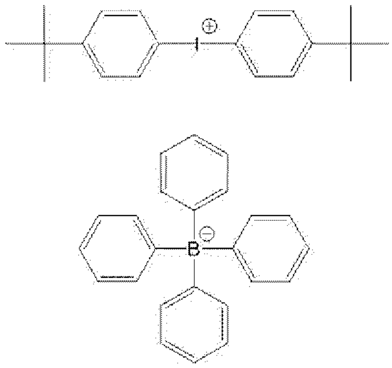

Iodonium salt 2

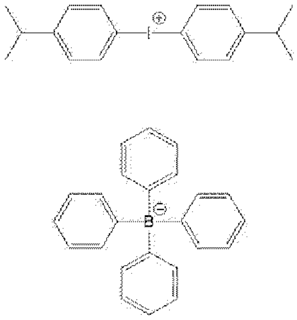

Leuco coloring agent

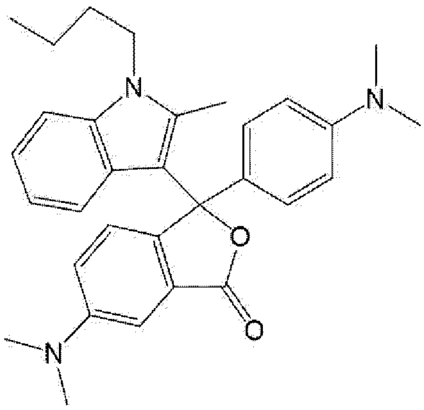

Phenothiazine

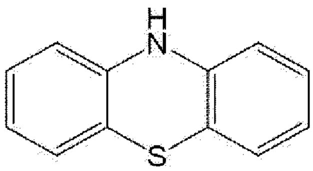

(Coating solution 2 for image recording layer)

The following components were mixed to prepare a coating solution 2 for an image recording layer.

- · Infrared absorber (IR-2): 0.0400 parts by mass
- · Color forming agent (S-22): 0.0200 parts by mass
- · Color forming agent (S-16): 0.0200 parts by mass
- · Electron-accepting polymerization initiator (Int-1): 0.1090 parts by mass
- · Electron-donating polymerization initiator (TPB): 0.0250 parts by mass
- · Polymerizable compound (M-4 shown below): 0.4714 parts by mass
- · Anionic surfactant (A-1): 0.0400 parts by mass
- · Fluorine-based surfactant (W-1): 0.0042 parts by mass
- · 2-Butanone: 4.3551 parts by mass
- · 1-Methoxy-2-propanol: 3.9260 parts by mass
- · Methanol: 2.6947 parts by mass
- · Polymer particles R: 2.3256 parts by mass

IR-2

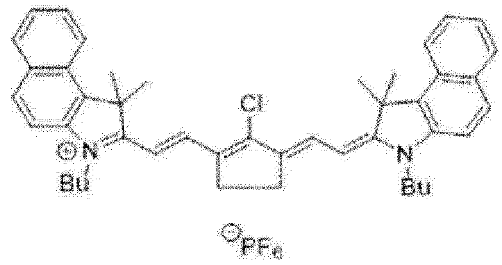

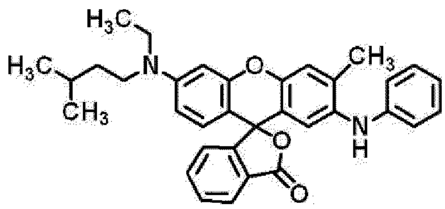

S - 22

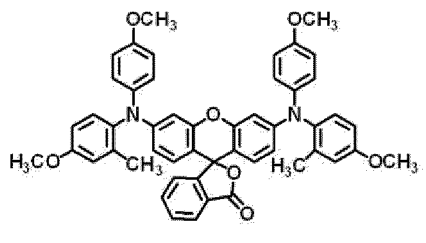

S - 16

Int-1

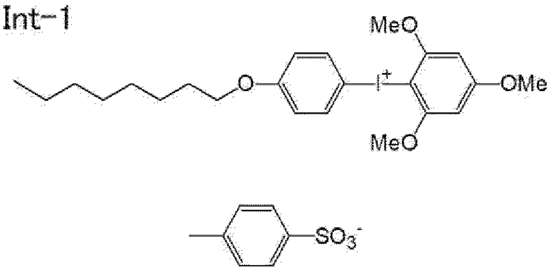

The energy level of HOMO of the electron-accepting polymerization initiator (Int-1) was -6.70 eV The energy level of LUMO of the electron-accepting polymerization initiator (Int-1) was -3.08 eV.

TPB

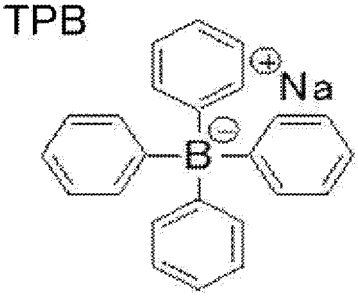

A-1

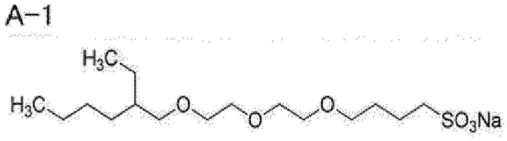

W-1

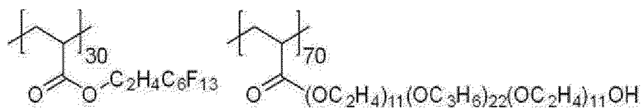

W - 1
Mw = 13,000

[Synthesis method of polymerizable compound (M-4)]

A mixed solution of TAKENATE D-160N (polyisocyanate trimethylolpropane adduct, manufactured by Mitsui Chemicals, Inc., 4.7 parts by mass), ARONIX M-403 (manufactured by Toagosei Co., Ltd., the amount was set such that the NCO value of TAKENATE D-160N and the hydroxyl value of ARONIX M-403 reached 1:1), t-butylbenzoquinone (0.02 parts by mass), and methyl ethyl ketone (11.5 parts by mass) was heated to 65°C. NEOSTANN U-600 (bismuth-based polycondensation catalyst, manufactured by Nitto Kasei Co., Ltd., 0.11 parts by mass) was added to the reaction solution, and the solution was heated at 65°C for 4 hours. The reaction solution was cooled to room temperature (25°C), and methyl ethyl ketone was added thereto, thereby synthesizing a urethane acrylate (M-4) solution having a solid content of 50% by mass.

[Preparation of polymer particles R]

- Preparation of oil phase component -

6.66 g of WANNATE (registered trademark) PM-200 (polyfunctional isocyanate compound: manufactured by Wanhua Chemical Group Co., Ltd.), 5.46 g of a 50 mass% ethyl acetate solution of TAKENATE (registered trademark) D-116N (adduct of trimethylolpropane (TMP), m-xylylene diisocyanate (XDI), and polyethylene glycol monomethyl ether (EO90) (following structure) manufactured by Mitsui Chemicals, Inc.), 11.24 g of a 65 mass% ethyl acetate solution of SR399 (dipentaerythritol pentaacrylate, manufactured by Sartomer Japan Inc.), 14.47 g of ethyl acetate, and 0.45 g of PIONIN (registered trademark) A-41-C (manufactured by TAKEMOTO OIL & FAT Co., Ltd.) were mixed and stirred at room temperature (25°C) for 15 minutes, thereby obtaining an oil phase component.

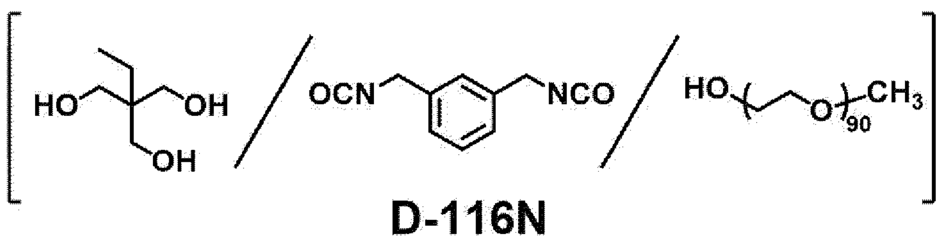

**D-116N**

- Preparation of water phase component -

As a water phase component, 47.2 g of distilled water was prepared.

- Microcapsule forming step -

A water phase component was added to and mixed with the oil phase component, and the obtained mixture was emulsified at 12,000 rpm for 16 minutes using a homogenizer to obtain an emulsion.

16.8 g of distilled water was added to the obtained emulsion, and the obtained liquid was stirred at room temperature for 180 minutes.

After stirring, the liquid was heated at 45°C, and stirred for 5 hours in a state of being kept at a liquid temperature 45°C such that ethyl acetate was distilled off from the liquid. The concentration of solid contents was adjusted to 20% by mass with distilled water, thereby obtaining an aqueous dispersion liquid of polymer particles R. The polymer particles R had a volume average particle diameter of 165 nm that was measured using a laser diffraction/scattering-type particle size distribution analyzer LA-920 (manufactured by HORIBA, Ltd.).

(Coating solution 3 for image recording layer)

The following components were mixed to prepare a coating solution 3 for an image recording layer.

· Infrared absorber (IR-1): 0.0120 parts by mass
· Infrared absorber (IR-2): 0.0250 parts by mass
· Color forming agent (S-22): 0.0200 parts by mass
· Color forming agent (S-16): 0.0200 parts by mass
· Electron-accepting polymerization initiator (Int-1): 0.1090 parts by mass
· Electron-donating polymerization initiator (TPB): 0.0250 parts by mass
· Polymerizable compound (M-4): 0.4714 parts by mass
· Anionic surfactant (A-1): 0.0400 parts by mass
· Fluorine-based surfactant (W-1): 0.0042 parts by mass
· 2-Butanone: 4.3551 parts by mass
· 1-Methoxy-2-propanol: 3.6383 parts by mass
· Methanol: 2.6947 parts by mass
· Polymer particles R: 2.6163 parts by mass

IR-1

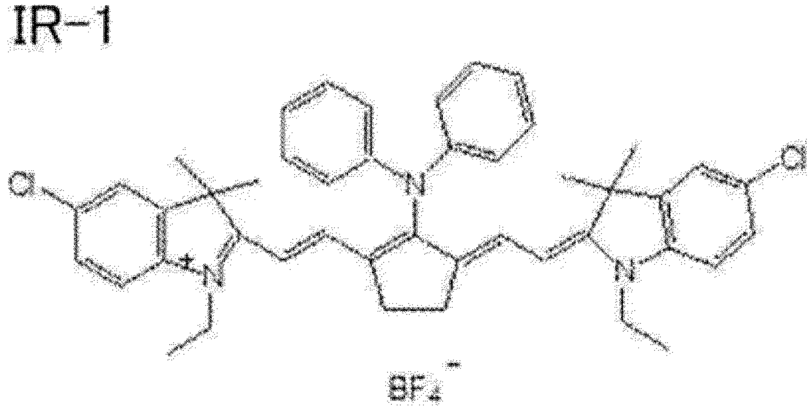

[Formation of protective layer]

The image recording layer of the aluminum support on which the image recording layer had been formed was bar-coated with the coating solution 1 or 2 for a protective layer and dried in an oven at 120°C for 60 seconds, thereby forming a protective layer having a dry coating amount of 0.80 $g/m^2$.

(Coating solution 1 for protective layer)

The following components were mixed to prepare a coating solution 1 for a protective layer.

· Inorganic lamellar compound dispersion liquid (1) [shown below]: 0.5625 parts by mass
· Hydrophilic polymer (1) (20% aqueous solution): 0.0825 parts by mass

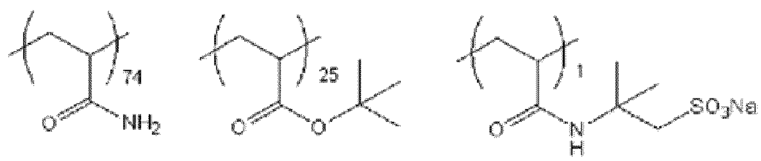

Hydrophilic polymer (1)

· METOLOSE SM04 (methyl cellulose, manufactured by Shin-Etsu Chemical Co., Ltd., methoxy substitution degree = 1.8): 0.0125 parts by mass
· RAPISOL A-80 (anionic surfactant, manufactured by NOF CORPORATION, 80% aqueous solution): 0.007 parts by mass
· Ion exchange water: 4.3355 parts by mass

The method of preparing the inorganic lamellar compound dispersion liquid (1) used in the coating solution for a protective layer is shown below.

- Preparation of inorganic lamellar compound dispersion liquid (1) -

6.4 parts by mass of synthetic mica (SOMASIF ME-100, manufactured by CO-OP CHEMICAL CO., LTD.) was added to 193.6 parts by mass of ion exchange water and dispersed such that the average particle diameter (laser scattering method) was set to 3 μm using a homogenizer. The aspect ratio of the obtained dispersed particles was 100 or greater.

(Coating solution 2 for protective layer)

The following components were mixed to prepare a coating solution 2 for a protective layer.

· Inorganic lamellar compound dispersion liquid (1) [shown below]: 0.5625 parts by mass
· Hydrophilic polymer (1) (20% aqueous solution): 0.0825 parts by mass
· METOLOSE SM04 (methyl cellulose, manufactured by Shin-Etsu Chemical Co., Ltd., methoxy substitution degree = 1.8): 0.0250 parts by mass
· RAPISOL A-80 (anionic surfactant, manufactured by NOF CORPORATION, 80% aqueous solution): 0.007 parts by mass
· Ion exchange water: 4.3300 parts by mass

[Evaluation method]

<Scratch resistance>

The scratch resistance was evaluated by using a surface property measuring machine TRIBOGEAR TYPE: 18LFW (manufactured by Shinto Scientific Co., Ltd.). The lithographic printing plate precursor produced above was scanned at a scanning speed of 20 mm/s while the load thereon was changed at intervals of 5 $g/m^2$ from 10 $g/m^2$ to 90 $g/m^2$ using a sapphire needle of 0.1 mm, to generate scratches. On-press development and printing were performed using the damaged lithographic printing plate precursor, and the load at which scratches and stains occurred on the 100th paper surface after the start of printing was evaluated.

10: No scratches and stains occurred even at a load of 90 $g/m^2$.
9: Scratches and stains occurred at a load of 90 $g/m^2$.
8: Scratches and stains occurred at a load of 85 $g/m^2$.
7: Scratches and stains occurred at a load of 75 or 80 $g/m^2$.
6: Scratches and stains occurred at a load of 65 or 70 $g/m^2$.
5: Scratches and stains occurred at a load of 55 or 60 $g/m^2$.
4: Scratches and stains occurred at a load of 45 or 50 $g/m^2$.

3: Scratches and stains occurred at a load of 35 or 40 g/$m^2$.
2: Scratches and stains occurred at a load of 25 or 30 g/$m^2$.
1: Scratches and stains occurred at a load of 20 g/$m^2$ or less.

<Oil-based cleaner printing durability>

The obtained lithographic printing plate precursors were exposed using Luxel PLATESETTER T-6000III (manufactured by Fujifilm Corporation) equipped with an infrared semiconductor laser under conditions of an external surface drum rotation speed of 1,000 rpm, a laser output of 70%, and a resolution of 2,400 dpi. The exposed image had a solid image and a 50% halftone dot chart of a 20 μm dot frequency modulation (FM) screen.

The obtained exposed lithographic printing plate precursor was attached to the plate cylinder of a printing press LITHRONE26 (manufactured by KOMORI Corporation) without performing a development treatment. Dampening water and ink were supplied by a standard automatic printing start method for LITHRONE26 using dampening water, in which the volume ratio of Ecolity-2 (manufactured by Fujifilm Corporation) to tap water was 2:98, and Values-G (N) black ink (manufactured by DIC Corporation) to perform on-press development, and then printing was performed on Tokubishi Art (76.5 kg) paper at a printing speed of 10,000 sheets per hour. As the number of printed sheets increased, the image recording layer was gradually abraded, and thus the ink density on the printed material decreased. The number of printed sheets at a time at which visual recognition that the density of the solid image began to decrease was made was defined as the standard number of printed sheets.

Next, the number of printed sheets at the time at which visual recognition that the density of the solid image began to decrease was made was acquired by the same method as described above except that a step of wiping the plate surface with a cleaner (manufactured by FUJIFILM Corporation, multi-cleaner) was provided every time 5,000 sheets were printed. The number of obtained printed sheets is defined as the number of evaluated printed sheets, and the value is listed in the following table.

In Table 3, the columns of "equivalent circular diameter" denote the average value of the equivalent circular diameters of projections in a cut surface at a position that is 0.5 μm greater than the position of projections with the average height.

In Table 3, the columns of "density of projections (pc/$mm^2$)" denote the density (pc/$mm^2$) of projections with a height of 0.5 μm or greater than the position of projections with the average height.

[Table 3]

| | Shape of support | | | | Anodized film | | | | | | | Formation | Printing performance | |
|---|---|---|---|---|---|---|---|---|---|---|---|---|---|---|
| | Equivalent circular diameter (μm) | Density of projections (pc/mm$^2$) | Density/ equivalent circular diameter | Specific surface area ΔS (%) | Large-diameter pore portions: Average diameter (nm) | Large-diameter pore portions: Depth (nm) | Inner diameter (nm) | Small-diameter pore portions: Average diameter (nm) | Small-diameter pore portions: Depth (nm) | Film amount (g/m2) | Density of micropores (pc/μm$^2$) | | Scratch resistance | Printing durability (× 10,000 sheets) |
| Example 1 | 3.2 | 4,800 | 1,500 | 38 | 30 | 110 | - | 12 | 1,000 | 2.5 | 500 | A | 8 | 5.5 |
| Example 2 | 5.7 | 4,000 | 702 | 37 | 30 | 110 | - | 12 | 1,000 | 2.5 | 500 | A | 7 | 5.8 |
| Example 3 | 9.8 | 4,900 | 500 | 48 | 30 | 110 | - | 12 | 1,000 | 2.5 | 500 | A | 6 | 6.2 |
| Example 4 | 6.2 | 3,100 | 500 | 34 | 30 | 110 | - | 12 | 1,000 | 2.5 | 500 | A | 5 | 4.8 |
| Example 5 | 6.5 | 6,600 | 1,015 | 34 | 30 | 110 | - | 12 | 1,000 | 2.5 | 500 | A | 7 | 5.2 |
| Example 6 | 6.1 | 8,800 | 1,443 | 37 | 30 | 110 | - | 12 | 1,000 | 2.5 | 500 | A | 8 | 6.3 |
| Example 7 | 5.8 | 5,200 | 897 | 33 | 30 | 110 | - | 12 | 1,000 | 2.5 | 500 | A | 7 | 5.0 |
| Example 8 | 4.5 | 5,100 | 1,133 | 33 | 30 | 110 | - | 12 | 1,000 | 22 | 500 | A | 6 | 5.1 |
| Example 9 | 5.6 | 5,100 | 911 | 21 | 30 | 110 | - | 12 | 1,000 | 2.5 | 500 | A | 6 | 4.2 |
| Example 10 | 5.6 | 5,100 | 911 | 47 | 30 | 110 | - | 12 | 1,000 | 2.5 | 500 | A | 6 | 7.0 |
| Example 11 | 4.4 | 5,000 | 1,136 | 38 | 30 | 110 | - | 12 | 1,200 | 3.0 | 500 | A | 8 | 5.1 |
| Example 12 | 4.4 | 5,000 | 1,136 | 38 | 30 | 110 | - | 12 | 1,280 | 3.2 | 500 | A | 9 | 5.1 |
| Example 13 | 4.4 | 5,200 | 1,182 | 36 | 30 | 110 | - | 12 | 1,360 | 3.4 | 500 | A | 10 | 5.3 |
| Example 14 | 4.4 | 5,100 | 1,159 | 35 | 30 | 110 | - | 12 | 1,600 | 4.0 | 500 | A | 10 | 5 |
| Example 15 | 4.7 | 4,800 | 1,021 | 35 | 30 | 110 | - | 12 | 1,800 | 4.5 | 500 | A | 10 | 5.2 |
| Example 16 | 5.5 | 5,300 | 9δ4 | 36 | 15 | 110 | - | 12 | 1,000 | 2.5 | 500 | A | 8 | 4.2 |
| Example 17 | 4.8 | 5,100 | 1,063 | 37 | 38 | 110 | - | 12 | 1,000 | 2.5 | 500 | A | 7 | 6.6 |
| Example 18 | 5.6 | 5,100 | 911 | 34 | 57 | 110 | - | 12 | 1,000 | 2.5 | 500 | A | 5 | 5.8 |
| Example 19 | 4.7 | 5,400 | 1,149 | 32 | 20 | 60 | 95 | 12 | 1,000 | 2.5 | 500 | A | 7 | 5.5 |
| Example 20 | 5.8 | 4,800 | 828 | 35 | 35 | 60 | 160 | 12 | 1,000 | 2.5 | 500 | A | 6 | 5.3 |
| Example 21 | 6.5 | 6,600 | 1,015 | 34 | 30 | 110 | - | 12 | 1,000 | 2.5 | 500 | B | 8 | 6.5 |

(continued)

| | Shape of support | | | | Anodized film | | | | | | | Formation | Printing performance | |
|---|---|---|---|---|---|---|---|---|---|---|---|---|---|---|
| | Equivalent circular diameter (μm) | Density of projections (pc/mm$^2$) | Density/ equivalent circular diameter | Specific surface area ΔS (%) | Large-diameter pore portions | | Inner diameter (nm) | Small-diameter pore portions | | Film amount (g/m2) | Density of micropores (pc/μm$^2$) | | Scratch resistance | Printing durability (× 10,000 sheets) |
| | | | | | Average diameter (nm) | Depth (nm) | | Average diameter (nm) | Depth (nm) | | | | | |
| Example 22 | 6.5 | 6,600 | 1,015 | 34 | 30 | 110 | - | 12 | 1,000 | 2.5 | 500 | C | 8 | 7.3 |
| Comparative Example 1 | 2.7 | 5,000 | 1,852 | 33 | 30 | 110 | - | 12 | 1,000 | 2.5 | 500 | A | 4 | 5.5 |
| Comparative Example 2 | 12 | 5,100 | 425 | 36 | 30 | 110 | - | 12 | 1,000 | 2.5 | 500 | A | 4 | 4.5 |
| Comparative Example 3 | 6.6 | 2,500 | 379 | 34 | 30 | 110 | - | 12 | 1,000 | 2.5 | 500 | A | 3 | 5.1 |
| Comparative Example 4 | 5.4 | 9,300 | 1,722 | 33 | 30 | 110 | - | 12 | 1,000 | 2.5 | 500 | A | 3 | 5.5 |
| Comparative Example 5 | 11 | 6,200 | 564 | 39 | 16 | 110 | - | 12 | 1,000 | 2.5 | 500 | A | 4 | 3.2 |
| Comparative Example 6 | 13 | 2,800 | 215 | 36 | 30 | 110 | - | 12 | 700 | 1.7 | 500 | A | 2 | 4.6 |

As listed in Table 3, it was confirmed that desired effects were obtained in a case where the support for a lithographic printing plate of the present invention was used.

Based on the comparison of Examples 1 to 3, it was confirmed that the effects were more excellent in a case where the average value of equivalent circular diameters was in a range of 3.0 to 6.5 μm.

Based on the comparison of Examples 4 to 6, it was confirmed that the effects were more excellent in a case where the density of the projections was in a range of 4,000 to 9,000 $pc/mm^2$.

As shown in the results of Examples 12 to 15, it was confirmed that the effects were more excellent in a case where the film amount was 3.2 $g/m^2$ or greater.

Based on the comparison of Examples 2 and 16 to 18, it was confirmed that the balance between the scratch resistance and the printing durability was excellent in a case where the average diameter of the micropores in the surface of the anodized film was in a range of 25 to 40 nm.

Based on the comparison between Examples 9 and 10, it was confirmed that the printing durability was excellent in a case where the amount of the second alkali etching was 0.20 $g/m^2$ or less.

Explanation of References

ta: anodic reaction time
tc: cathodic reaction time
tp: time taken for current to reach peak from 0
Ia: peak current on anode cycle side
Ic: peak current on cathode cycle side
10: support for lithographic printing plate
12: aluminum plate
14A, 14B, 14C: anodized film
16A: first projection
16B: second projection
16C: third projection
20, 30: micropore
22: large-diameter pore portion
24: small-diameter pore portion
32: upper pore portion
34: lower pore portion
36: small-diameter upper pore portion
38: large-diameter upper pore portion
40: lithographic printing plate precursor
42: support for lithographic printing plate
44: undercoat layer
46: image recording layer
50: main electrolytic cell
51: AC power source
52: radial drum roller
53a, 53b: main pole
54: electrolytic liquid feed inlet
55: electrolytic solution
56: auxiliary anode
60: auxiliary anode cell
W: aluminum plate
610: anodization treatment device
612: power supply tank
614: electrolytic treatment tank
616: aluminum plate
618, 626: electrolytic solution
620: power supply electrode
622, 628: roller
624: nip roller
630: electrolytic electrode

632: tank wall
634: DC power source

## Claims

**1.** A support for a lithographic printing plate, comprising:

an aluminum plate; and
an anodized aluminum film disposed on the aluminum plate,
wherein a plurality of projections are present on a surface of the support for a lithographic printing plate on a side of the anodized film,
an average value of equivalent circular diameters of the projections in a cut surface at a position that is 0.5 μm greater than a position of the projections with an average height is in a range of 3.0 to 10.0 μm, and
a density of the projections with a height of 0.5 μm or greater from the position of the projections with the average height is in a range of 3,000 to 9,000 pc/mm$^2$.

**2.** The support for a lithographic printing plate according to claim 1,
wherein the average value of the equivalent circular diameters is in a range of 3.0 to 6.5 μm.

**3.** The support for a lithographic printing plate according to claim 1 or 2,
wherein the density of the projections is in a range of 4,000 to 9,000 pc/mm$^2$.

**4.** The support for a lithographic printing plate according to any one of claims 1 to 3,
wherein a ratio of the density to the average value of the equivalent circular diameters is 500 (pc/mm$^2$)/μm or greater.

**5.** The support for a lithographic printing plate according to any one of claims 1 to 4,
wherein an amount of the anodized film is 2.0 g/m$^2$ or greater.

**6.** The support for a lithographic printing plate according to any one of claims 1 to 5,
wherein an amount of the anodized film is 3.2 g/m$^2$ or greater.

**7.** The support for a lithographic printing plate according to any one of claims 1 to 6,
wherein a surface area ratio ΔS calculated according to Equation (1), from a geometrically measured area S0 and an actual area Sx determined by an approximate three-point method from three-dimensional data obtained by measuring 512 × 512 points with an area of 25 μm × 25 μm on the surface on the side of the anodized film using an atomic force microscope, is 20% or greater,

$$\Delta S = (Sx - S0)/S0 \times 100\ (\%) \cdots (1).$$

**8.** The support for a lithographic printing plate according to any one of claims 1 to 7,

wherein the anodized film has micropores,
the micropores are formed of large-diameter pore portions extending to a position at a depth of 10 to 1,000 nm from the surface of the anodized film and small-diameter pore portions communicating with bottom portions of the large-diameter pore portions and extending to a position at a depth of 20 to 2,000 nm from communication positions,
an average diameter of the large-diameter pore portions in the surface of the anodized film is in a range of 18 to 60 nm, and
an average diameter of the small-diameter pore portions at the communication positions is 15 nm or less.

**9.** The support for a lithographic printing plate according to any one of claims 1 to 7,

wherein the anodized film has micropores,
the micropores are formed of upper pore portions extending in a depth direction from the surface of the anodized film and lower pore portions communicating with bottom portions of the upper pore portions and extending to a position at a depth of 20 to 2,000 nm from communication positions,

an average diameter of the upper pore portions in the surface of the anodized film is in a range of 18 to 60 nm,
a maximum diameter of the upper pore portions is 200 nm or less,
an average diameter of the lower pore portions at the communication positions is 15 nm or less, and
a ratio of the maximum diameter of the upper pore portions to the average diameter of the upper pore portions in the surface of the anodized film is 1.2 or greater.

**10.** The support for a lithographic printing plate according to claim 8 or 9,
wherein a density of the micropores is in a range of 300 to 2,000 pc/$\mu m^2$.

**11.** A lithographic printing plate precursor comprising:

the support for a lithographic printing plate according to any one of claims 1 to 10; and
an image recording layer.

**12.** The lithographic printing plate precursor according to claim 11,
wherein the lithographic printing plate precursor is of an on-press development type.

**13.** A method of producing a lithographic printing plate, comprising:

a step of image-exposing the lithographic printing plate precursor according to claim 11 to an infrared laser; and
a step of removing an unexposed portion of the image recording layer on a printing press by at least one selected from a printing ink or dampening water.

FIG. 1

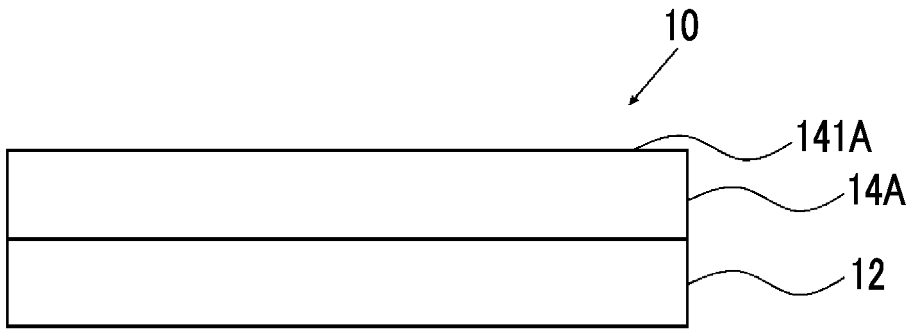


FIG. 2

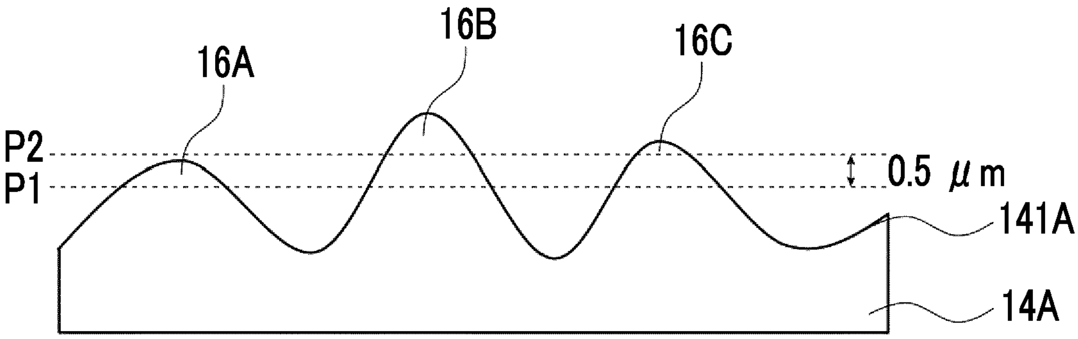


FIG. 3

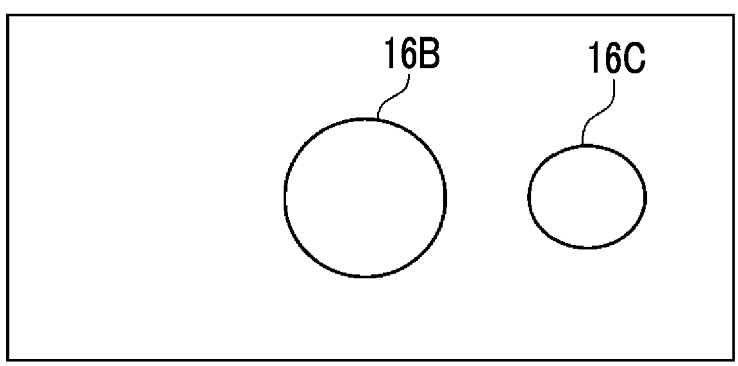

FIG. 4

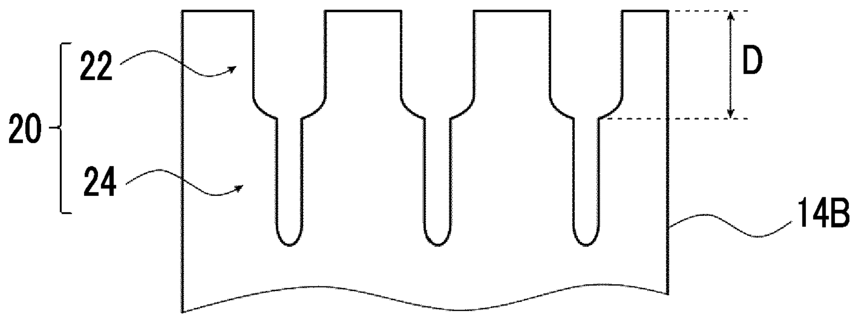


FIG. 5

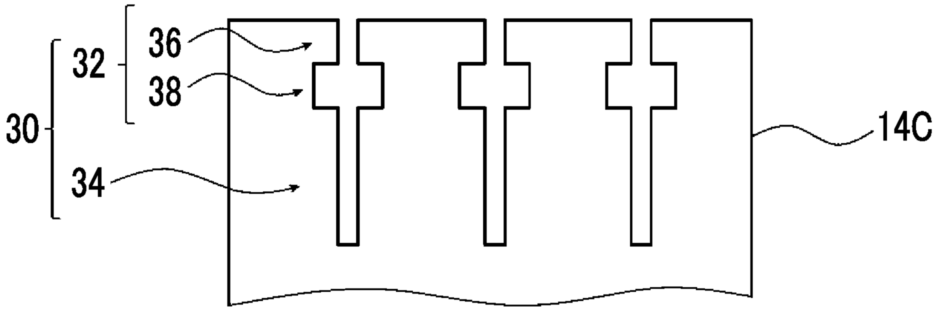


FIG. 6

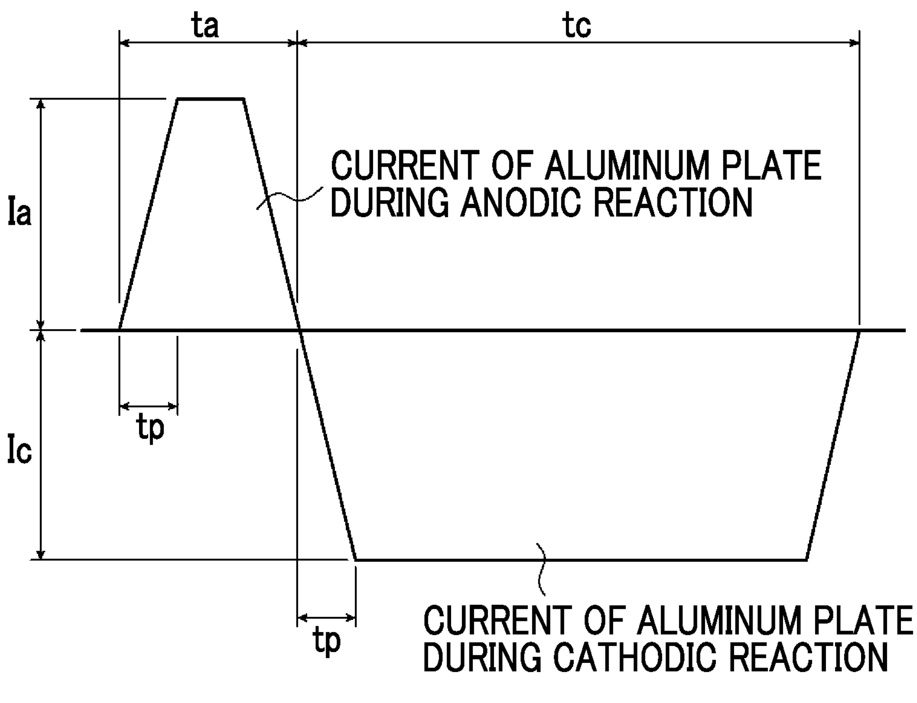

FIG. 7

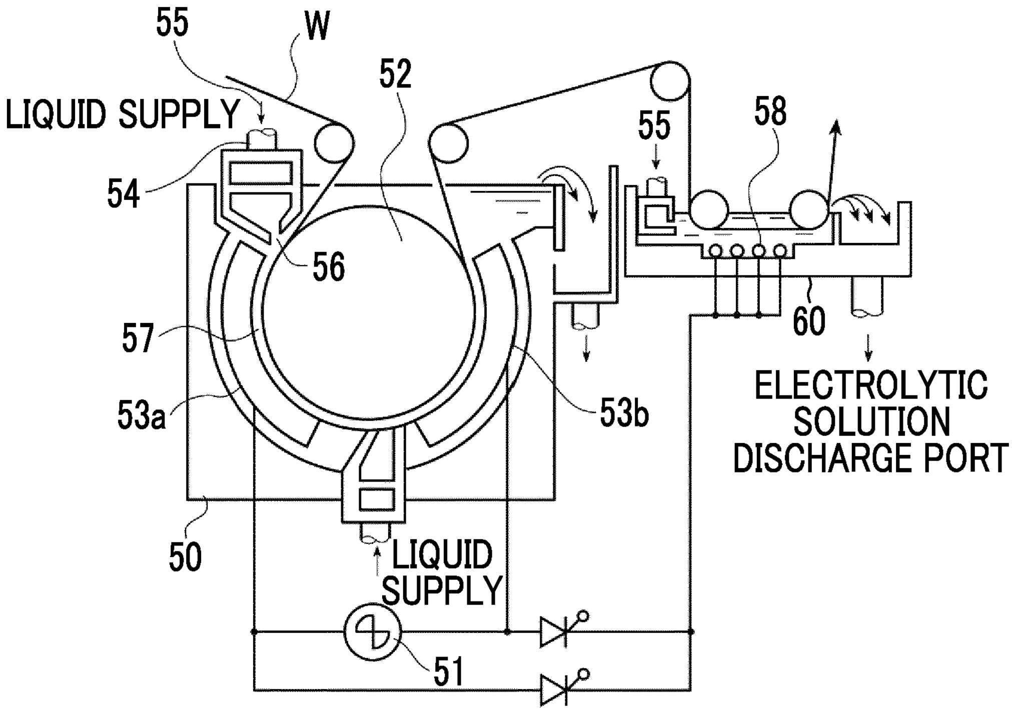


FIG. 8

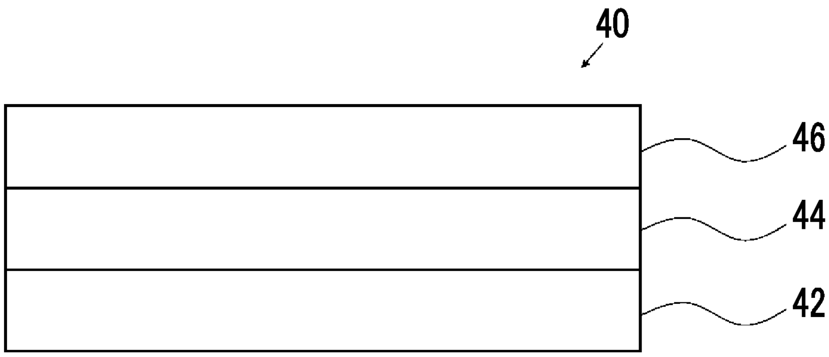


FIG. 9

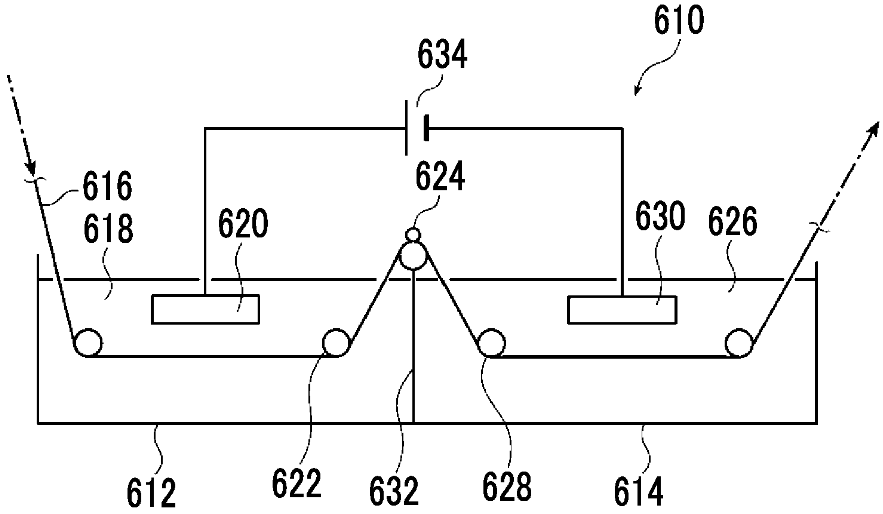

## INTERNATIONAL SEARCH REPORT

International application No.
**PCT/JP2022/032630**

**A. CLASSIFICATION OF SUBJECT MATTER**

***B41N 3/03***(2006.01)i; ***B41C 1/10***(2006.01)i; ***B41N 1/08***(2006.01)i
FI: B41N3/03; B41C1/10; B41N1/08

According to International Patent Classification (IPC) or to both national classification and IPC

**B. FIELDS SEARCHED**

Minimum documentation searched (classification system followed by classification symbols)

B41N3/03; B41C1/10; B41N1/08

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2008-119881 A (KONICA MINOLTA MEDICAL & GRAPHIC INC) 29 May 2008 (2008-05-29)<br>entire text | 1-13 |
| A | JP 2006-240116 A (FUJI PHOTO FILM CO LTD) 14 September 2006 (2006-09-14)<br>entire text, all drawings | 1-13 |
| A | JP 2005-262530 A (FUJI PHOTO FILM CO LTD) 29 September 2005 (2005-09-29)<br>entire text | 1-13 |
| A | WO 2021/132647 A1 (FUJIFILM CORPORATION) 01 July 2021 (2021-07-01)<br>entire text | 1-13 |
| A | WO 2019/044087 A1 (FUJIFILM CORPORATION) 07 March 2019 (2019-03-07)<br>entire text, all drawings | 1-13 |
| A | US 2012/0138481 A1 (COLEMAN, Andrew) 07 June 2012 (2012-06-07)<br>entire text, all drawings | 1-13 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 October 2022** | **08 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/032630**

| Patent document cited in search report | Publication date (day/month/year) | Patent family member(s) | Publication date (day/month/year) |
|---|---|---|---|
| JP 2008-119881 A | 29 May 2008 | (Family: none) | |
| JP 2006-240116 A | 14 September 2006 | (Family: none) | |
| JP 2005-262530 A | 29 September 2005 | US 2005/0208422 A1<br>EP 1577115 A2 | |
| WO 2021/132647 A1 | 01 July 2021 | (Family: none) | |
| WO 2019/044087 A1 | 07 March 2019 | US 2019/0061404 A1<br>EP 3476616 A1 | |
| US 2012/0138481 A1 | 07 June 2012 | WO 2010/127903 A1<br>EP 2427584 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019087516 A
- JP 6135175 A
- JP H6135175 A
- JP 50040047 B
- JP S50040047 B
- US 3276868 A
- US 4153461 A
- US 4689272 A
- JP 2001312068 A
- JP 2008195018 A
- JP 2009255434 A
- JP 48041708 B
- JP S48041708 B
- JP 2012187907 A
- JP 2005254638 A
- US 2714066 A
- US 3181461 A
- EP 1765593 A


### Non-patent literature cited in the description


- Dye Handbook. 1970